# EUROPEAN PATENT APPLICATION

(11) **EP 4 783 228 A1**
(43) Date of publication of application: **29.07.2026**
(21) Application number: 24868037.3
(22) Date of filing: 26.08.2024
(51) Int. Cl.: H01L 21/304, B08B 3/08, H01L 21/027, H01L 21/306

(54) **SUBSTRATE PROCESSING DEVICE AND SUBSTRATE PROCESSING METHOD**

(30) Priority: 22.09.2023 JP 2023159045; 19.03.2024 JP 2024043839
(71) Applicant: SCREEN Holdings Co., Ltd., Kyoto-shi, Kyoto 602-8585 (JP)
(72) Inventor: ENDO, Toru, Kyoto-shi, Kyoto 602-8585 (JP); YASHIKI, Hiroyuki, Kyoto-shi, Kyoto 602-8585 (JP); WAKITA, Asuka, Kyoto-shi, Kyoto 602-8585 (JP)
(74) Representative: Kilian Kilian & Partner mbB
(86) International application number: PCT/JP2024/030342
(87) International publication number: WO 2025/062957

(57) **Abstract**

A substrate processing apparatus 1 includes a water flow passage that guides water toward a substrate W, and a solvent flow passage 33x that guides an organic solvent, which is a liquid having a surface tension lower than that of water, toward the substrate W. The water flow passage includes an uneven surface 72 including a concave portion 72u at least partially filled with air and a convex portion 72h in contact with water in contact with the air in the concave portion 72u. The solvent flow passage 33x includes the mirror surface 71 in contact with the organic solvent.

## Description

### Related Application

This application claims priority based on Japanese Patent Application No. 2023-159045 filed on September 22, 2023 and Japanese Patent Application No. 2024-043839 filed on March 19, 2024, the entire contents of which are incorporated herein by reference.

### Technical Field

The present invention relates to a substrate processing apparatus and a substrate processing method that process a substrate. Examples of substrates include semiconductor wafers, substrates for FPDs (flat panel displays) such as liquid crystal display devices, organic EL (electroluminescence) display devices, etc., substrates for optical disks, substrates for magnetic disks, substrates for magneto-optical disks, substrates for photomasks, ceramic substrates, substrates for solar cells, etc.

### Background Art

Patent Literature 1 discloses that a piping is cleaned with a cleaning liquid before starting use of a substrate processing apparatus installed in a plant.

### Citation List

### Patent Literature

Patent Literature 1: Japanese Patent Application Publication No. 2020-155649

### Summary of Invention

### Technical Problem

While a piping is being cleaned, substrates cannot be processed with a substrate processing apparatus. Therefore, it is preferable that the time for cleaning a member forming a flow path such as the piping is short. Also, the frequency of cleaning is preferably low.

A preferred embodiment of the present invention provides a substrate processing apparatus and a substrate processing method capable of reducing the time for cleaning a flow path that guides a processing liquid to be supplied to a substrate.

Also, a preferred embodiment of the present invention provides a substrate processing apparatus and a substrate processing method capable of reducing the frequency of cleaning a flow passage that guides a processing liquid to be supplied to a substrate.

### Solution to Problem

A preferred embodiment of the present invention provides a substrate processing apparatus including: a substrate holder that holds a substrate; a water flow path that guides water toward the substrate held by the substrate holder; and a solvent flow path that guides an organic solvent, which is a liquid having a surface tension lower than that of the water, toward the substrate held by the substrate holder, wherein the water flow path includes an uneven surface including a concave portion at least partially filled with air and a convex portion in contact with the water in contact with the air in the concave portion, and wherein the solvent flow path includes a mirror surface that is in contact with the organic solvent.

In the above preferred embodiment, at least one of the following features may be added to the substrate processing apparatus.

The uneven surface is made of fluororesin.

The water flow path includes a water tank that stores the water and a water piping that guides the water supplied from the water tank, and wherein the uneven surface is provided on an inner surface of the water tank.

The solvent flow path includes a solvent tank that stores the organic solvent and a solvent piping that guides the organic solvent supplied from the solvent tank, and wherein the mirror surface is provided on an inner surface of the solvent tank.

The uneven surface is provided at a bent portion of the water flow path.

The substrate processing apparatus further includes a high-temperature chemical liquid flow path that guides a high-temperature chemical liquid having a temperature higher than room temperature toward a substrate held by the substrate holder, wherein the high-temperature chemical liquid flow path includes an uneven surface including a concave portion at least partially filled with air and a convex portion in contact with the high-temperature chemical liquid in contact with the air in the concave portion.

The uneven surface of the high-temperature chemical liquid flow path is made of fluororesin.

The high-temperature chemical liquid flow path includes a high-temperature chemical liquid tank that stores the high-temperature chemical liquid, and a high-temperature chemical liquid piping that guides the high-temperature chemical liquid supplied from the high-temperature chemical liquid tank, and wherein the uneven surface of the high-temperature chemical liquid flow path is provided on an inner surface of the high-temperature chemical liquid tank.

The high-temperature chemical liquid flow path includes a high-temperature chemical liquid piping that guides the high-temperature chemical liquid, and a high-temperature chemical liquid nozzle that discharges the high-temperature chemical liquid guided by the high-temperature chemical liquid piping, and wherein the uneven surface of the high-temperature chemical liquid flow path is provided on an inner surface of the high-temperature chemical liquid nozzle.

The uneven surface is provided at a bent portion of the high-temperature chemical liquid flow path.

Another preferred embodiment of the present invention provides a substrate processing method including: a water supplying step of guiding water toward a substrate held by a substrate holder by a water flow path including an uneven surface in a state where at least a portion of a concave portion of the uneven surface is filled with air and a convex portion of the uneven surface is in contact with the water in contact with the air in the concave portion; and a solvent supplying step of guiding, before or after the water supplying step, an organic solvent toward the substrate held by the substrate holder by a solvent flow path including a mirror surface, in a state where the mirror surface is in contact with the organic solvent which is a liquid having a surface tension lower than that of the water. The following feature may be added to this preferred embodiment, and at least one of the aforementioned features relating to the substrate processing apparatus may be added to the substrate processing method.

The substrate processing method further includes a high-temperature chemical liquid supplying step of guiding a high-temperature chemical liquid having a temperature higher than room temperature toward the substrate held by the substrate holder, wherein the high-temperature chemical liquid supplying step includes a step of causing the high-temperature chemical liquid to flow through a high-temperature chemical liquid flow path including the uneven surface in a state where at least a portion of the concave portion of the uneven surface is filled with air and the convex portion of the uneven surface is in contact with the high-temperature chemical liquid in contact with the air in the concave portion.

Still another preferred embodiment of the present invention provides a substrate processing apparatus including: a substrate holder that holds a substrate; and a high-temperature chemical liquid flow path that guides a high-temperature chemical liquid having a temperature higher than room temperature toward a substrate held by the substrate holder, wherein the high-temperature chemical liquid flow path includes an uneven surface including a concave portion at least partially filled with air and a convex portion in contact with the high-temperature chemical liquid in contact with the air in the concave portion.

In the above preferred embodiment, at least one of the following features may be added to the substrate processing apparatus.

The substrate processing apparatus further includes a solvent flow path that guides an organic solvent, which is a liquid having a surface tension lower than that of the high-temperature chemical liquid toward the substrate held by the substrate holder, wherein the solvent flow path includes a mirror surface in contact with the organic solvent.

The uneven surface is made of fluororesin.

The high-temperature chemical liquid flow path includes a high-temperature chemical liquid tank that stores the high-temperature chemical liquid, and a high-temperature chemical liquid piping that guides the high-temperature chemical liquid supplied from the high-temperature chemical liquid tank, and wherein the uneven surface is provided on an inner surface of the high-temperature chemical liquid tank.

The high-temperature chemical liquid flow path includes a high-temperature chemical liquid piping that guides the high-temperature chemical liquid, and a high-temperature chemical liquid nozzle that discharges the high-temperature chemical liquid guided by the high-temperature chemical liquid piping, and wherein the uneven surface is provided on an inner surface of the high-temperature chemical liquid nozzle.

The uneven surface is provided at a bent portion of the high-temperature chemical liquid flow path.

Still another preferred embodiment of the present invention provides a substrate processing method including: a high-temperature chemical liquid supplying step of guiding a high-temperature chemical liquid having a temperature higher than room temperature toward a substrate held by a substrate holder, wherein the high-temperature chemical liquid supplying step includes a step of causing the high-temperature chemical liquid to flow through a high-temperature chemical liquid flow path including the uneven surface in a state where at least a portion of the concave portion of the uneven surface is filled with air and the convex portion of the uneven surface is in contact with the high-temperature chemical liquid in contact with the air in the concave portion. The following feature may be added to this preferred embodiment, and at least one of the aforementioned features relating to the substrate processing apparatus may be added to the substrate processing method.

The substrate processing method further includes a solvent supplying step of guiding, before or after the high-temperature chemical liquid supplying step, an organic solvent toward the substrate held by the substrate holder by a solvent flow passage including a mirror surface, in a state where the mirror surface is in contact with an organic solvent, which is a liquid having a surface tension lower than that of the high-temperature chemical liquid.

The above and yet other objects, features, and effects of the present invention will become more apparent from the following description of the preferred embodiments made with reference to the attached drawings.

### Brief Description of Drawings

[FIG. 1A] is a schematic plan view showing a layout of a substrate processing apparatus according to a preferred embodiment of the present invention.
[FIG. 1B] is a schematic side view of the substrate processing apparatus.
[FIG. 2] is a schematic view as viewed horizontally of an interior of a processing unit included in the substrate processing apparatus.
[FIG. 3] is a block diagram showing an electrical configuration of the substrate processing apparatus.
[FIG. 4] is a process diagram for explaining an example of substrate processing performed by the substrate processing apparatus.
[FIGS. 5A and 5B] are schematic views of a processing liquid supply system of the substrate processing apparatus that supplies a processing liquid to a substrate.
[FIG. 6] is a schematic sectional view showing an example of a droplet in contact with a smooth surface.
[FIG. 7] is a schematic sectional view showing an example of a droplet in contact with a rough surface in a Wenzel state.
[FIG. 8] is a schematic sectional view showing an example of a droplet in contact with a rough surface in a Cassie-Baxter state.
[FIG. 9] is a schematic sectional view showing an example of a boundary between a liquid contact portion and liquid.
[FIG. 10] is a schematic view showing an example of a cross section of a bent portion of a chemical liquid piping.
[FIG. 11] is a schematic view showing an example of a cross section of a bent portion taken along line XI-XI shown in FIG. 10.
[FIG. 12] is a schematic view showing an example of a cross section of a mold for manufacturing a chemical liquid piping.
[FIG. 13] is a schematic view showing an example of a cross section of a mold taken along line XIII-XIII shown in FIG. 12.
[FIG. 14] is a schematic sectional view showing a substrate processing apparatus according to another preferred embodiment of the present invention.
[FIG. 15] is a schematic view showing another configuration example of a processing unit provided in the substrate processing apparatus.
[FIG. 16] is a process diagram for explaining a substrate processing example in a case where the processing unit of FIG. 15 is used.
[FIG. 17] is a schematic view of a supply system of a processing liquid containing a high-temperature chemical liquid.
[FIG. 18] is a transverse sectional view for explaining a structure example of a high-temperature chemical liquid piping.

### Description of Embodiments

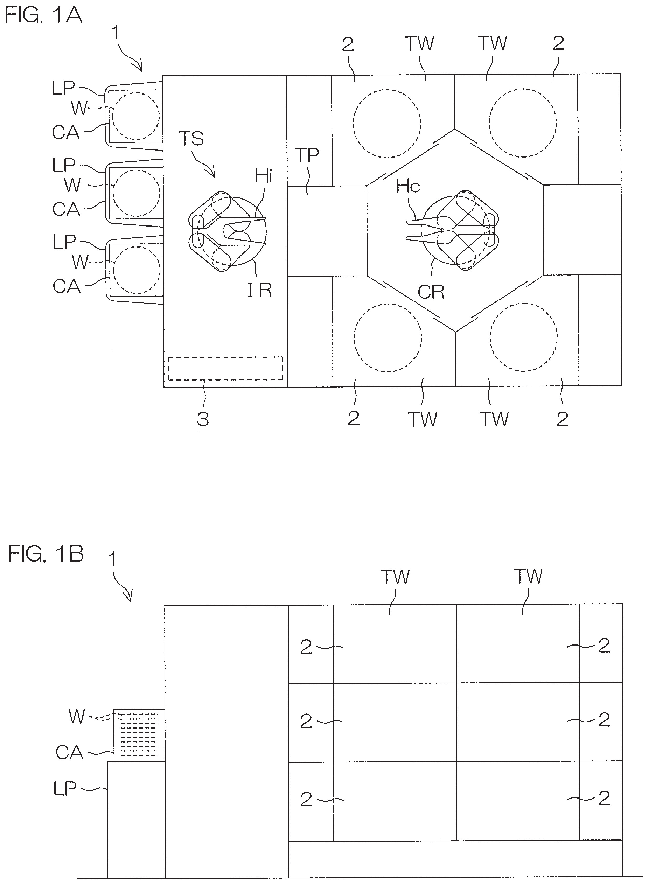

FIG. 1A is a schematic plan view showing a layout of a substrate processing apparatus 1 according to a preferred embodiment of the present invention. FIG. 1B is a schematic side view of the substrate processing apparatus 1.

The substrate processing apparatus 1 is a single substrate processing type apparatus that processes disk-shaped substrates W, such as semiconductor wafers, etc., one by one. The substrate processing apparatus 1 includes a load port LP that holds a carrier CA housing the substrate W, a plurality of processing units 2 that process the substrate W transferred from the carrier CA on the load port LP with a processing fluid such as a processing liquid or a processing gas, a transfer system TS that transfers the substrate W between the carrier CA on the load port LP and the plurality of processing units 2, and a controller 3 that controls the substrate processing apparatus 1.

The plurality of processing units 2 form a plurality of towers TW. FIG. 1A shows an example in which four towers TW are formed. As shown in FIG. 1B, the plurality of processing units 2 included in a single tower TW are stacked vertically. As shown in FIG. 1A, the plurality of towers TW form two rows extending in a depth direction of the substrate processing apparatus 1 in plan view. In plan view, the two rows face each other through the transfer passage TP.

The transfer system TS includes an indexer robot IR that transfers the substrate W between the carrier CA on the load port LP and the plurality of processing units 2, and a center robot CR that transfers the substrate W between the indexer robot IR and the plurality of processing units 2. The indexer robot IR is disposed between the load port LP and the center robot CR in plan view. The center robot CR is disposed on the transfer passage TP.

The indexer robot IR includes one or more hands Hi that support the substrates W horizontally. Each hand Hi is movable in parallel in both a horizontal direction and a vertical direction. The hand Hi is rotatable around a vertical straight line. The hand Hi can perform carry-in and carry-out of the substrates W with respect to the carrier CA on any load port LP, and can receive and deliver the substrate W from and to the center robot CR.

The center robot CR includes one or more hands Hc that support the substrates W horizontally. Each hand Hc is movable in parallel in both the horizontal direction and the vertical direction. The hand Hc is rotatable around a vertical straight line. The hand Hc can receive and deliver the substrate W from and to the indexer robot IR, and can perform carry-in and carry-out of the substrates W with respect to any processing unit 2.

Next, the processing unit 2 shall be described.

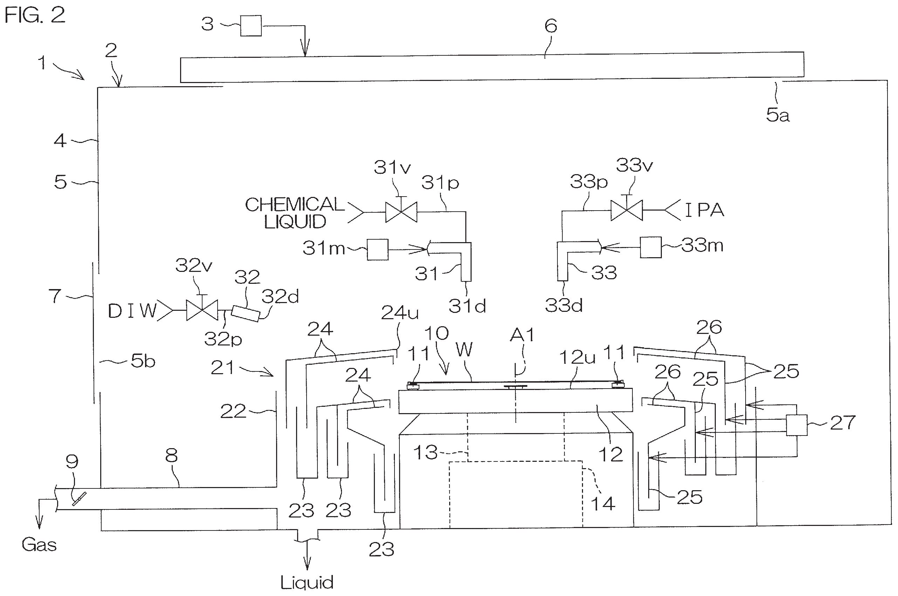

FIG. 2 is a schematic view as viewed horizontally of an interior of a processing unit 2 included in the substrate processing apparatus 1. The processing unit 2 includes a box-shaped chamber 4, having an internal space, a spin chuck 10, holding a single substrate W in a horizontal orientation inside the chamber 4 and meanwhile rotating the substrate W around a vertical rotational axis A1 passing through a central portion of the substrate W, and a cylindrical processing cup 21, surrounding the spin chuck 10 around the rotational axis A1.

The chamber 4 includes a box-shaped partition wall 5 provided with a carry-in/carry-out port 5b through which the substrate W passes, and a door 7 that opens and closes the carry-in/carry-out port 5b. An FFU 6 (fan filter unit) is disposed above an air blowing port 5a provided at an upper portion of the partition wall 5. The FFU 6 constantly supplies clean air (air filtered by a filter) into the chamber 4 from the air blowing port 5a. Gas inside the chamber 4 is exhausted from the chamber 4 through an exhaust duct 8 connected to a bottom portion of the processing cup 21. A down flow of clean air is thereby formed constantly inside the chamber 4. A flow rate of exhaust exhausted to the exhaust duct 8 is changed in accordance with an opening degree of an exhaust valve 9 disposed inside the exhaust duct 8.

The spin chuck 10 includes a disk-shaped spin base 12, held horizontally, a plurality of chuck pins 11, holding the substrate W horizontally above the spin base 12, a spin shaft 13, extending downward from a central portion of the spin base 12, and a spin motor 14, rotating the spin shaft 13 to rotate the spin base 12 and the plurality of chuck pins 11.

The spin chuck 10 is not restricted to a clamping type chuck, with which the plurality of chuck pins 11 are made to contact an end surface of the substrate W, and may instead be a vacuum type chuck that holds the substrate W horizontally by suctioning a rear surface (lower surface) of the substrate W, which is a non-device forming surface, onto an upper surface 12u of the spin base 12. When the spin chuck 10 is a clamping type chuck, the plurality of chuck pins 11 correspond to a substrate holder. When the spin chuck 10 is a vacuum type chuck, the spin base 12 corresponds to a substrate holder.

The processing cup 21 includes a plurality of guards 24, receiving a processing liquid expelled outward from the substrate W, a plurality of cups 23, receiving the processing liquid guided downward by the plurality of guards 24, and a circular cylindrical outer wall member 22, surrounding the plurality of guards 24 and the plurality of cups 23. FIG. 2 shows an example where four guards 24 and three cups 23 are provided and the cup 23 at an outermost side is made integral to the third top guard 24.

Each guard 24 includes a circular cylindrical portion 25, surrounding the spin chuck 10, and a circular annular ceiling portion 26, extending obliquely upward toward the rotational axis A1 from an upper end portion of the circular cylindrical portion 25. The plurality of ceiling portions 26 are overlapped one above the other, and the plurality of circular cylindrical portions 25 are disposed concentrically. A circular annular upper ends of the ceiling portions 26 correspond to upper ends 24u of the guards 24 surrounding the substrate W and the spin base 12 in plan view. The plurality of cups 23 are respectively disposed below the plurality of circular cylindrical portions 25. The cups 23 form annular grooves that receive the processing liquid guided downward by the guards 24.

The processing unit 2 includes a guard elevating/lowering unit 27 that elevates and lowers the plurality of guards 24 individually. The guard elevating/lowering unit 27 positions each guard 24 at any position within a range from an upper position to a lower position. FIG. 2 shows a state where two guards 24 are disposed at the upper positions and the remaining two guards 24 are disposed at the lower positions. The upper position is a position at which the upper end 24u of the guard 24 is disposed higher than a holding position, at which the substrate W held by the spin chuck 10 is disposed. The lower position is a position at which the upper end 24u of the guard 24 is disposed lower than the holding position.

The processing unit 2 includes a plurality of nozzles discharging processing fluids toward the substrate W held by the spin chuck 10. The plurality of nozzles include a chemical liquid nozzle 31 that discharges a chemical liquid toward an upper surface of the substrate W and a rinse liquid nozzle 32 that discharges a rinse liquid toward the upper surface of the substrate W. The plurality of nozzles further include a solvent nozzle 33 that discharges an organic solvent toward the upper surface of the substrate W. FIG. 2 illustrates an example in which the rinse liquid nozzle 32 discharges DIW (deionized water) and the solvent nozzle 33 discharges IPA (isopropyl alcohol). DIW represents pure water (deionized water). The organic solvent represents a liquid of the organic solvent unless noted in particular otherwise. The same applies to IPA.

The chemical liquid nozzle 31 is connected to a chemical liquid piping 31p that guides the chemical liquid. When a chemical liquid valve 31v attached to the chemical liquid piping 31p is opened, the chemical liquid is continuously discharged downward from a discharge port 31d of the chemical liquid nozzle 31. The chemical liquid may be a liquid containing at least one of sulfuric acid, nitric acid, hydrochloric acid, hydrofluoric acid, phosphoric acid, acetic acid, ammonia water, hydrogen peroxide water, an organic acid (for example, citric acid, oxalic acid, etc.), an organic alkali (for example, TMAH: tetramethylammonium hydroxide, etc.), a surfactant, and a corrosion inhibitor or may be a liquid other than these.

Although not illustrated, the chemical liquid valve 31v includes a valve body that is provided with a valve seat of annular shape through which the chemical liquid passes, a valve element that is movable with respect to the valve seat, and an actuator that moves the valve element between a closed position at which the valve element contacts the valve seat and an open position at which the valve element is separated from the valve seat. The same also applies to the other valves. The actuator may be a pneumatic actuator or an electric actuator or an actuator besides these. The controller 3 controls the actuator to open and close the chemical liquid valve 31v, etc.

The rinse liquid nozzle 32 is connected to a rinse liquid piping 32p that guides the rinse liquid. When a rinse liquid valve 32v attached to the rinse liquid piping 32p is opened, the rinse liquid is continuously discharged downward from a discharge port 32d of the rinse liquid nozzle 32. The rinse liquid may be any of pure water, carbonated water, electrolyzed ion water, hydrogen water, ozone water, and aqueous hydrochloric acid solution of dilute concentration (for example of approximately 10 to 100 ppm) and may be a liquid other than these.

The solvent nozzle 33 is connected to a solvent piping 33p that guides the organic solvent. When a solvent valve 33v attached to the solvent piping 33p is opened, the organic solvent is continuously discharged downward from a discharge port 33d of the solvent nozzle 33. The organic solvent may be an alcohol other than IPA, or may be an organic solvent other than an alcohol such as HFE (hydrofluoroether). IPA has a vapor pressure higher than that of water and a surface tension lower than that of water.

The chemical liquid nozzle 31 may be a scan nozzle that moves the collision position of the chemical liquid with respect to the substrate W within the upper surface of the substrate W, or may be a fixed nozzle that cannot move the collision position of the chemical liquid with respect to the substrate W. The same applies to other nozzles. FIG. 2 shows an example in which the chemical liquid nozzle 31 and the solvent nozzle 33 are scan nozzles, and the rinse liquid nozzle 32 is a fixed nozzle.

The chemical liquid nozzle 31 is connected to a nozzle moving unit 31m that moves the chemical liquid nozzle 31 in at least one of the vertical direction and the horizontal direction. The nozzle moving unit 31m horizontally moves the chemical liquid nozzle 31 between a processing position (position shown in FIG. 2) where the chemical liquid discharged from the chemical liquid nozzle 31 is supplied to the upper surface of the substrate W and a standby position where the chemical liquid nozzle 31 is positioned around the processing cup 21 in plan view.

The solvent nozzle 33 is connected to a nozzle moving unit 33m that moves the solvent nozzle 33 in at least one of the vertical direction and the horizontal direction. The nozzle moving unit 33m horizontally moves the solvent nozzle 33 between a processing position (position shown in FIG. 2) where the organic solvent discharged from the solvent nozzle 33 is supplied to the upper surface of the substrate W and a standby position where the solvent nozzle 33 is positioned around the processing cup 21 in plan view.

Next, an electrical configuration of the substrate processing apparatus 1 shall be described.

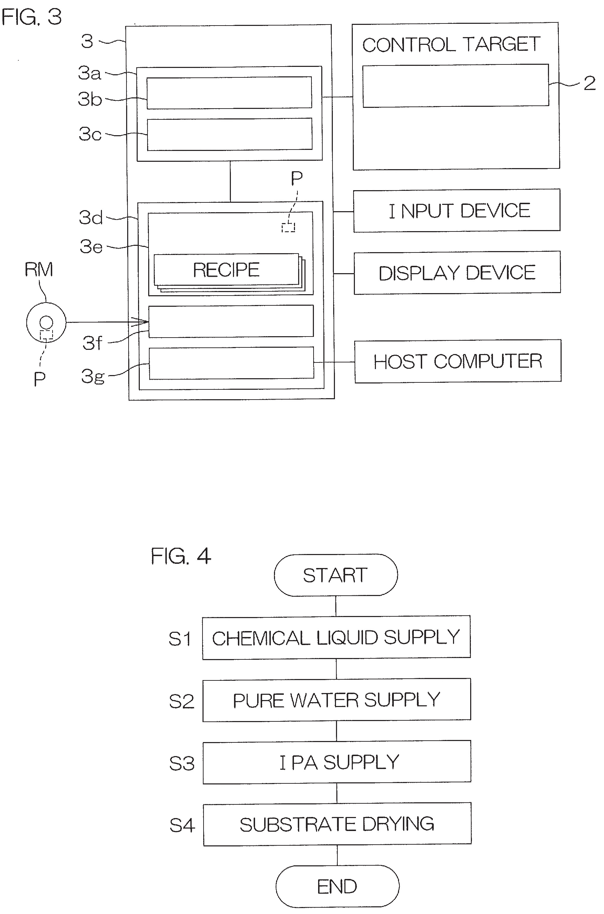

FIG. 3 is a block diagram of an electrical configuration of the substrate processing apparatus 1. The controller 3 includes at least one computer. The computer includes a computer main body 3a and a peripheral unit 3d connected to the computer main body 3a. The computer main body 3a includes a CPU 3b (central processing unit) that executes various instructions and a memory 3c that stores information. The peripheral unit 3d includes a storage 3e that stores information to be transmitted to and received from the memory 3c such as a program P, a reader 3f that reads information from a removable medium RM, and a communication unit 3g that communicates with another device such as a host computer. Each of the memory 3c and the storage 3e is an example of a storage device that stores information to be transmitted to and received from the CPU 3b.

The controller 3 is connected to an input device and a display device. The input device is operated when an operator, such as a user or maintenance staff, etc., inputs information into the substrate processing apparatus 1. The information is displayed on the screen of the display device. The input device may be any of a keyboard, a pointing device, and a touch panel or may be a device besides these. The substrate processing apparatus 1 may be provided with a touch panel display that serves as both the input device and the display device.

The CPU 3b executes the program P stored in the storage 3e. The program P within the storage 3e may be installed in the controller 3 in advance, may be fed through the reader 3f from the removable medium RM to the storage 3e, or may be fed from an external device such as the host computer to the storage 3e through the communication device 3g.

The memory 3c is a volatile memory that holds storage only when power is supplied. The storage 3e and the removable medium RM are nonvolatile memories that hold storage even when power is not supplied. The storage 3e is, for example, a magnetic storage device such as a hard disk drive. The removable medium RM is, for example, an optical disc such as a compact disc or a semiconductor memory such as a memory card. The removable medium RM is an example of a computer-readable recording medium on which the program P is recorded. The removable medium RM is a non-transitory tangible recording medium.

The storage 3e stores a plurality of recipes. Each recipe is information specifying processing contents, processing conditions, and processing procedures for the substrate W. The plurality of recipes differ from each other in at least one of the processing contents, the processing conditions, and the processing procedures for the substrate W. The controller 3 controls the substrate processing apparatus 1 such that the substrate W is processed in accordance with the recipe designated by the host computer. The controller 3 is programmed to execute the following respective steps.

Next, an example of processing of the substrate W will be described.

FIG. 4 is a process diagram for explaining an example of processing the substrate W performed by the substrate processing apparatus 1. In the following, FIG. 1A, FIG. 2, and FIG. 4 shall be referenced.

When the substrate W is processed, the indexer robot IR carries out the substrate W from the carrier CA on any one of the load ports LP. The center robot CR carries the substrate W, that have been carried out by the indexer robot IR, into any one of the processing units 2 and places the substrate W on the spin chuck 10. Thereafter, the plurality of chuck pins 11 are horizontally pressed against the end surface of the substrate W, and the spin motor 14 starts to rotate. The rotation of the substrate W is thereby started.

When the rotation of the substrate W is started, the chemical liquid valve 31v is opened, and the chemical liquid nozzle 31 discharges the chemical liquid toward the upper surface of the rotating substrate W. A liquid film of the chemical liquid covering the entire upper surface of the substrate W is thereby formed (step S1 in FIG. 4: an example of a water supplying step). When the chemical liquid nozzle 31 is discharging the chemical liquid, the nozzle moving unit 31m may move the chemical liquid nozzle 31 such that a collision position of the chemical liquid with respect to the upper surface of the substrate W passes through a central portion and an outer peripheral portion, or may stop the chemical liquid nozzle 31 such that the collision position stops at the central portion. Whether or not to move the collision position is the same for other processing liquids.

When a predetermined time elapses after the chemical liquid valve 31v is opened, the chemical liquid valve 31v is closed and the rinse liquid valve 32v is opened. In response to this, the rinse liquid nozzle 32 discharges pure water, which is an example of the rinse liquid, toward the upper surface of the rotating substrate W. The chemical liquid on the substrate W is thereby replaced with pure water, and a liquid film of pure water covering the entire upper surface of the substrate W is formed (step S2 in FIG. 4: an example of a water supplying step). Thereafter, the rinse liquid valve 32v is closed, and the solvent valve 33v is opened. In response to this, the solvent nozzle 33 discharges IPA, which is an example of an organic solvent, toward the upper surface of the rotating substrate W. Pure water on the substrate W is thereby replaced with IPA, and a liquid film of IPA covering the entire upper surface of the substrate W is formed (step S3 in FIG. 4: an example of a solvent supplying step). Thereafter, the solvent valve 33v is closed.

When the solvent valve 33v is closed, the spin motor 14 rotates the substrate W held by the plurality of chuck pins 11 at a high rotation speed (for example, several thousand rpm). The liquid is thereby removed from the substrate W, and the substrate W is dried (step S4 in FIG. 4). After the substrate W is dried, the spin motor 14 is stopped, and the plurality of chuck pins 11 are separated from the end surface of the substrate W. The rotation of the substrate W is thereby stopped, and the holding of the substrate W is released. Thereafter, the center robot CR carries out the substrate W from the processing unit 2. The indexer robot IR carries the substrate W, that have been carried out by the center robot CR, into the carrier CA on one of the load ports LP.

Thus, a single substrate W is processed with a processing liquid such as a chemical liquid or a rinse liquid. The controller 3 causes the substrate processing apparatus 1 to repeat the above series of operations by controlling the indexer robot IR, etc. The plurality of substrates W are thereby processed one by one.

Next, a processing liquid supply system of the substrate processing apparatus 1 shall be described.

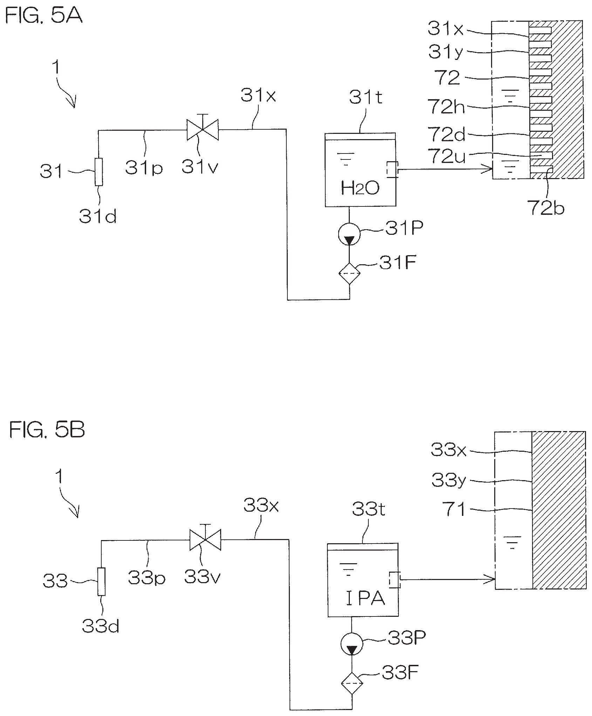

FIG. 5A is a schematic view of a chemical liquid supply system of the substrate processing apparatus 1 that supplies a chemical liquid to the substrate W. In addition to the chemical liquid nozzle 31, the chemical liquid piping 31p, and the chemical liquid valve 31v, the substrate processing apparatus 1 includes a chemical liquid tank 31t that stores a chemical liquid to be supplied to the chemical liquid nozzle 31. The substrate processing apparatus 1 further includes a chemical liquid pump 31P that feeds the chemical liquid in the chemical liquid tank 31t toward the chemical liquid nozzle 31, and a chemical liquid filter 31F that removes foreign matter from the chemical liquid fed from the chemical liquid tank 31t. An upstream end of the chemical liquid piping 31p is connected to the chemical liquid tank 31t. A downstream end of the chemical liquid piping 31p is connected to the chemical liquid nozzle 31.

FIG. 5B is a schematic view of a solvent supply system of the substrate processing apparatus 1 that supplies an organic solvent to the substrate W. The substrate processing apparatus 1 includes a solvent tank 33t that stores an organic solvent to be supplied to the solvent nozzle 33 in addition to the solvent nozzle 33, the solvent piping 33p, and the solvent valve 33v. The substrate processing apparatus 1 further includes a solvent pump 33P that feeds the organic solvent in the solvent tank 33t toward the solvent nozzle 33, and a solvent filter 33F that removes foreign matter from the organic solvent fed from the solvent tank 33t. An upstream end of the solvent piping 33p is connected to the solvent tank 33t. A downstream end of the solvent piping 33p is connected to the solvent nozzle 33.

The chemical liquid is an aqueous solution of a chemical. "H2O" in FIG. 5A represents water contained in the chemical liquid. The surface tension of the chemical liquid is the same as or substantially the same as the surface tension of water (H2O). The surface tension of the chemical liquid is higher than the surface tension of an organic solvent such as IPA. In the following description, water means a liquid having a concentration of water (H2O) of 100% or substantially 100%, or a liquid having a surface tension equal to or substantially equal to a surface tension of water (H2O), unless noted in particular otherwise. As long as such conditions are satisfied, the water may contain a substance other than water (H2O). The rinse liquid such as pure water is an example of water. The chemical liquid is another example of water.

The organic solvent is a liquid having a surface tension lower than that of water (H2O). As long as the organic solvent has a surface tension lower than that of water (H2O), the organic solvent may be a liquid constituted of one substance or a liquid containing a plurality of substances. In the latter case, the organic solvent may contain water (H2O). The organic solvent may be a liquid in which, when the organic solvent is brought into contact with an uneven surface 72 described later, a concave portion 72u is filled with an organic solvent and a convex portion 72h is in contact with the organic solvent. In the following, water and an organic solvent may be collectively referred to at times as a processing liquid.

A path through which the chemical liquid passes until being discharged from the discharge port 31d of the chemical liquid nozzle 31 corresponds to one chemical liquid flow passage 31x continuous from a start position to a goal position. A path through which the organic solvent passes until being discharged from the discharge port 33d of the solvent nozzle 33 corresponds to one solvent flow passage 33x continuous from a start position to a goal position. Although not shown, a path through which the rinse liquid passes before being discharged from the discharge port 32d of the rinse liquid nozzle 32 corresponds to one rinse liquid flow passage continuous from a start position to a goal position.

The chemical liquid flow passage 31x is an example of one continuous water flow passage from a start position to a goal position. The rinse liquid flow passage is also an example of the water flow passage. The structure of the rinse liquid flow passage is the same as the structure of the chemical liquid flow passage 31x except that pure water is supplied not from a tank such as the chemical liquid tank 31t but from a utility piping provided in a plant where the substrate processing apparatus 1 is installed. Therefore, in the following, the description of the rinse liquid flow passage shall be omitted.

The chemical liquid tank 31t corresponds to the start position of the chemical liquid flow passage 31x. The discharge port 31d of the chemical liquid nozzle 31 corresponds to the goal position of the chemical liquid flow passage 31x. Similarly, the solvent tank 33t corresponds to the start position of the solvent flow passage 33x. The discharge port 33d of the solvent nozzle 33 corresponds to the goal position of the solvent flow passage 33x. When the processing liquid is supplied from the utility piping provided in the plant in which the substrate processing apparatus 1 is installed to the chemical liquid flow passage 31x or the solvent flow passage 33x, the start position does not have to be the chemical liquid tank 31t or the solvent tank 33t but may be the upstream end of the chemical liquid piping 31p or the solvent piping 33p, or may be a joint that connects the chemical liquid piping 31p or the solvent piping 33p to the utility piping.

Only one start position may be provided in one chemical liquid flow passage 31x, or a plurality of start positions may be provided in one chemical liquid flow passage 31x. Similarly, only one goal position may be provided in one chemical liquid flow passage 31x, or a plurality of goal positions may be provided in one chemical liquid flow passage 31x. For example, the processing liquid supplied from one start position may be discharged from a plurality of goal positions. When the mixed liquid of a first component liquid and a second component liquid is discharged, the chemical liquid flow passage 31x may include a start position of the first component liquid, a start position of the second component liquid, and one or more goal positions that discharges the first component liquid and the second component liquid mixed downstream of the two start positions. The same applies to the start position and the goal position of the solvent flow passage 33x.

The chemical liquid flow passage 31x includes the chemical liquid nozzle 31 provided with the discharge port 31d that discharges a chemical liquid, and the chemical liquid piping 31p that guides the chemical liquid toward the chemical liquid nozzle 31. The chemical liquid flow passage 31x may further include a fluid device other than the chemical liquid nozzle 31 and the chemical liquid piping 31p.

Specifically, in place of or in addition to at least one of the chemical liquid valve 31v, the chemical liquid tank 31t, the chemical liquid pump 31P, and the chemical liquid filter 31F, the chemical liquid flow passage 31x may further include at least one of a circulation piping that circulates the chemical liquid in the chemical liquid tank 31t upstream of the chemical liquid piping 31p, a flow control valve that changes a flow rate of the chemical liquid supplied to the chemical liquid nozzle 31, a flow meter that measures a flow rate of the chemical liquid supplied to the chemical liquid nozzle 31, a joint that connects two or more pipings, a manifold that connects three or more pipings, a heater that heats the chemical liquid, and a cooler that cools the chemical liquid.

As with the chemical liquid flow passage 31x, the solvent flow passage 33x includes the solvent nozzle 33 provided with the discharge port 33d that discharges an organic solvent, and the solvent piping 33p that guides the organic solvent toward the solvent nozzle 33. The solvent flow passage 33x may further include a fluid device other than the solvent nozzle 33 and the solvent piping 33p such as the solvent valve 33v. Specific examples of the fluid device are similar to those described above.

The chemical liquid flow passage 31x includes an internal space in which a flowing or stationary chemical liquid is disposed, and a cylindrical inner surface 31y surrounding the entire circumference of the internal space. The internal space of the chemical liquid flow passage 31x is a sealed space opened only at the goal position of the chemical liquid flow passage 31x. In other words, the internal space of the chemical liquid flow passage 31x is in contact with the space outside the chemical liquid flow passage 31x only at the goal position of the chemical liquid flow passage 31x.

As with the chemical liquid flow passage 31x, the solvent flow passage 33x includes an internal space in which a flowing or stationary organic solvent is disposed, and a cylindrical inner surface 33y surrounding the entire circumference of the internal space. The internal space of the solvent flow passage 33x is a sealed space opened only at the goal position of the solvent flow passage 33x. In other words, the internal space of the solvent flow passage 33x is in contact with the space outside the solvent flow passage 33x only at the goal position of the solvent flow passage 33x.

The inner surface 31y of the chemical liquid flow passage 31x and the inner surface 33y of the solvent flow passage 33x are made of a resin such as fluororesin. The fluororesin may be PTFE (polytetrafluoroethylene) or PFA (perfluoroalkoxy alkane), or may be other than these. The entire inner surface 31y of the chemical liquid flow passage 31x may be made of the same material, or a portion of the inner surface 31y of the chemical liquid flow passage 31x may be made of a material different from the remaining portion of the inner surface 31y of the chemical liquid flow passage 31x. The same applies to the inner surface 33y of the solvent flow passage 33x.

As shown in an enlarged manner on the right side of FIG. 5B, the inner surface 33y of the solvent flow passage 33x includes a mirror surface 71 in contact with the organic solvent in the solvent flow passage 33x. The mirror surface 71 is a surface subjected to mirror finishing for reducing the surface roughness. Mirror finishing may be polishing or may be other than this.

As shown in an enlarged manner on the right side of FIG. 5A, the inner surface 31y of the chemical liquid flow passage 31x includes an uneven surface 72 in contact with the chemical liquid in the chemical liquid flow passage 31x. The uneven surface 72 is a rough surface having a surface roughness larger than that of the mirror surface 71. In other words, the mirror surface 71 is a smooth surface having a surface roughness smaller than that of the uneven surface 72.

The entire inner surface 31y of the chemical liquid flow passage 31x may be the uneven surface 72, or only a portion of the inner surface 31y of the chemical liquid flow passage 31x may be the uneven surface 72. The same applies to the mirror surface 71. FIG. 5A shows an example in which all or portion of the inner surface of the chemical liquid tank 31t is the uneven surface 72. FIG. 5B shows an example in which all or portion of the inner surface of the solvent tank 33t is the mirror surface 71.

The uneven surface 72 is a water repellent surface subjected to a water repellent finishing for increasing a contact angle of a water such as a chemical liquid or a rinse liquid. The water repellent finishing may be at least one of cutting, laser processing, plastic processing, extrusion molding, blasting, and etching, or may be other than these.

Cutting may be or may be at least one of lathing and milling, or may be other than these. Blasting is a process (such as shot blasting) in which solid particles are made to collide with a surface of an object. Etching is a process of corroding a surface of an object with a chemical. Water repellent finishing may be a process for transferring, to an object, the unevenness of a surface of a mold. In this case, water repellent finishing may be at least one of plastic processing and extrusion molding, or may be other than these.

As shown in FIG. 5A, the uneven surface 72 is a solid surface provided with a plurality of the concave portions 72u and a plurality of the convex portions 72h. The concave portion 72u is recessed from a tip 72d of the convex portion 72h. The convex portion 72h protrudes from a bottom 72b of the concave portion 72u. The bottom 72b of the concave portion 72u corresponds to a proximal portion of the convex portion 72h. The tip 72d of the convex portion 72h corresponds to an opening end of the concave portion 72u. The tips 72d of the two adjacent convex portions 72h form an inlet of the concave portion 72u positioned therebetween.

The convex portion 72h may have a linear shape in which the depth is longer than the width, a point shape in which the depth is equal to or substantially equal to the width, or may be other than these. The same applies to the concave portion 72u. The cross section of the convex portion 72h may be any one of a rectangle, a square, a triangle, an inverted triangle, a trapezoid, an inverted trapezoid, and a semicircle, or may be other than these. The same applies to the cross section of the concave portion 72u. FIG. 5A shows an example in which the cross sections of the convex portion 72h and the concave portion 72u are rectangular. The height (length in the left-right direction in FIG. 5A) of the convex portion 72h may be uniform or may be non-uniform. The same applies to the depth of the concave portion 72u. The height of the convex portion 72h may be equal to or may be different from the width of the convex portion 72h (the length in the vertical direction in FIG. 5A). The depth of the concave portion 72u may be equal to or may be different from the width of the concave portion 72u.

A solid surface is said to have hydrophilicity when the water contact angle is less than 90 degrees. When the water contact angle is not less than 90 degrees, the solid surface is said to have water repellency or hydrophobicity. When the water contact angle is not less than 150 degrees, the solid surface is said to have super water repellency. The water contact angle with respect to the smooth surface made of fluororesin may exceed 90 degrees or may be not more than 90 degrees. The water contact angle with respect to the smooth surface made of PTFE is said to be 104 to 114 degrees. The water contact angle with respect to the smooth surface made of PFA is said to be 105 to 118 degrees. The water contact angle with respect to the uneven surface 72 may be not less than 119 degrees, and preferably not less than 150 degrees. The water contact angle with respect to the mirror surface 71 may be less than 100 degrees.

Next, the contact between the droplet and the uneven surface 72 and the mirror surface 71 shall be described.

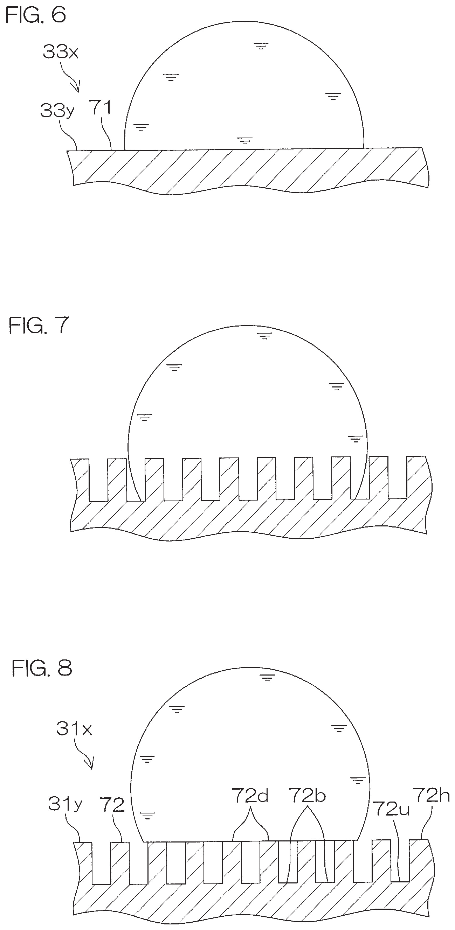

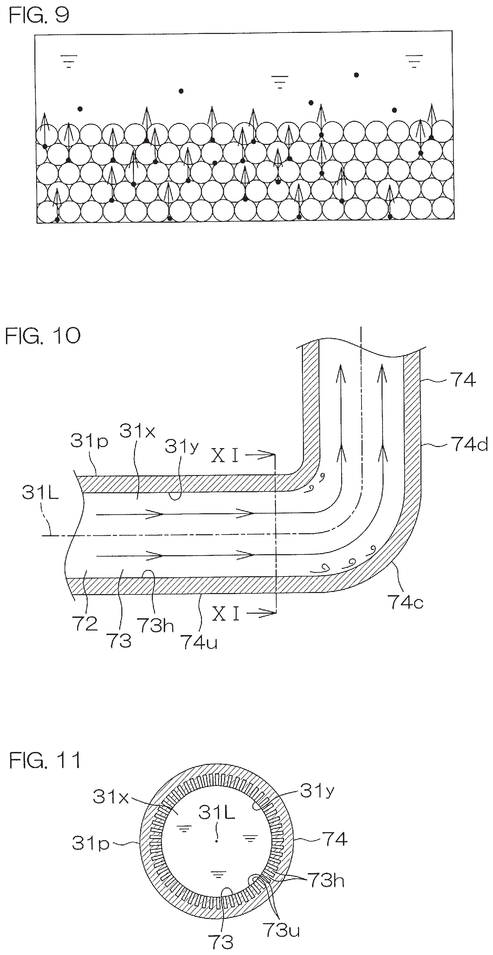

FIG. 6 is a schematic sectional view showing an example of a droplet in contact with a smooth surface. FIG. 7 is a schematic sectional view showing an example of a droplet in contact with a rough surface in a Wenzel state. FIG. 8 is a schematic sectional view showing an example of a droplet in contact with a rough surface in a Cassie-Baxter state. FIG. 9 is a schematic sectional view showing an example of a boundary between a liquid contact portion and liquid.

As shown in FIG. 8, the uneven surface 72 is a surface on which, when a water droplet is placed on the horizontal uneven surface 72 under an environment of normal temperature and normal pressure (under an environment of room temperature and 1 atm), the tip 72d of the convex portion 72h comes into contact with the water droplet in a state where the bottom 72b of the concave portion 72u is separated from the water droplet. In other words, the uneven surface 72 is a surface that becomes a Cassie-Baxter state when a water droplet is placed on the horizontal uneven surface 72 under an environment of normal temperature and normal pressure. The room temperature is a constant or substantially constant temperature, for example in a range of 10 to 30°C.

The Cassie-Baxter model and the Wenzel model are models used in describing wetting of a rough surface. As shown in FIG. 7, in the Wenzel state (hereinafter, also referred to as a W state.), water droplet on the horizontal rough surface enters the recesses. On the other hand, as shown in FIG. 8, in the Cassie-Baxter state (hereinafter, also referred to as a CB state.), the concave portions 72u are filled with air, and the water droplet is supported by the tips 72d of the convex portions 72h.

Whether the water droplet on the rough surface takes on the W state or the CB state is affected by factors such as a surface tension of the liquid, a surface free energy of the rough surface (solid), and a surface texture of the rough surface. It is considered that, as the surface tension of the liquid is higher and the surface free energy of the rough surface is lower (the water repellency of the rough surface is higher), the water droplets on the rough surface are more likely to be in the CB state.

The inner surface 31y of the chemical liquid flow passage 31x is made of a water repellent material having a water contact angle exceeding 90 degrees with respect to a horizontal smooth surface. Therefore, when the surface property of the uneven surface 72 satisfies the conditions, the water droplet comes into contact with the horizontal uneven surface 72 in the CB state. That is, when a water droplet is placed on the horizontal uneven surface 72 under an environment of normal temperature and normal pressure, the tips 72d of the convex portions 72h come into contact with the water droplet in a state where the bottoms 72b of the concave portions 72u are separated from the water droplet. As long as the water droplet comes into contact with the horizontal uneven surface 72 in the CB state in an environment of normal temperature and normal pressure, the chemical liquid in the chemical liquid flow passage 31x may come into contact with all or portion of the uneven surface 72 in the W state.

As can be seen from comparison between FIG. 7 and FIG. 8, when a case where a water droplet comes into contact with the horizontal uneven surface 72 in the CB state and a case where the water droplet comes into contact with the horizontal uneven surface 72 in the W state are compared, a contact area between the water droplet and the uneven surface 72 is smaller in a case where the water droplet comes into contact with the horizontal uneven surface 72 in the CB state. Further, the water contact angle with respect to the uneven surface 72 is larger when the water droplet comes into contact with the horizontal uneven surface 72 in the CB state.

The solvent flow passage 33x is a flow passage in contact with an organic solvent such as IPA. The inner surface 33y of the solvent flow passage 33x is made of a water repellent material having a water contact angle exceeding 90 degrees with respect to a horizontal smooth surface. However, since the surface tension of the organic solvent is low, even when the inner surface 33y of the solvent flow passage 33x is a rough surface, the organic solvent in the solvent flow passage 33x comes into contact with the inner surface 33y of the solvent flow passage 33x in the W state. As can be seen from comparison between FIG. 6 and FIG. 7, when a case where the inner surface 33y of the solvent flow passage 33x is the mirror surface 71 is compared with a case where the inner surface 33y is the rough surface, a contact area between the droplet of the organic solvent and the inner surface 33y of the solvent flow passage 33x is smaller when the inner surface 33y of the solvent flow passage 33x is the mirror surface 71.

FIG. 9 shows an example of an image of a boundary between the liquid contact portion and the liquid. A large circle in FIG. 9 represents a molecule of a fluororesin. Small black circles in FIG. 9 represent impurities. FIG. 9 shows an example in which impurities are smaller than molecules of a fluororesin. The size of the impurities is not limited thereto.

The inner surface 31y (see FIG. 8) of the chemical liquid flow passage 31x and the inner surface 33y (see FIG. 6) of the solvent flow passage 33x are liquid contact portions in contact with liquid. The inner surface of the rinse liquid flow passage is also included in the liquid contact portion. The liquid contact portion is made of a resin such as a fluororesin. As shown in FIG. 9, the fluororesin may contain impurities (small black circles in FIG. 9) different from the fluororesin in some cases. Such impurities may be eluted into liquid from the liquid contact portion in some cases. In order to prevent this, when the substrate processing apparatus 1 is started up, that is, when preparing to use the substrate processing apparatus 1 in a plant such as a semiconductor manufacturing plant, the liquid contact portion is cleaned with a cleaning liquid. Such cleaning is also referred to as flushing.

However, even after the cleaning is performed, the impurities move from an interior of the fluororesin to the surface of the fluororesin. When a period during which the substrate processing apparatus 1 does not process the substrate W (a period during which the liquid does not flow along the liquid contact portion) is long, a large amount of impurities are accumulated in the liquid contact portion, and when the processing of the substrate W is resumed, the impurities are eluted from the liquid contact portion into the liquid. Therefore, when the period during which the substrate processing apparatus 1 does not process the substrate W is long, it is necessary to perform cleaning before resuming the processing of the substrate W.

When cleaning is performed, not only the cleaning liquid but also energy such as electric power is used. When the time required for cleaning is long, the energy consumption amount and the use amount of the cleaning liquid increase. The same applies to a case where the number of times of cleaning is large. In order to reduce the cost required for cleaning and a load on the environment, it is desirable to reduce the time required for cleaning and the number of times of cleaning.

On the other hand, even when the substrate processing apparatus 1 continues to process the substrate W or even when the period during which the substrate processing apparatus 1 does not process the substrate W is short, contaminants such as impurities may be eluted into the liquid from the liquid contact portion in some cases. For example, in a region where the fluidity of the liquid is low (a region where stagnation and/or retention of the liquid occurs), it is considered that many impurities are accumulated in the liquid contact portion and are eluted from the liquid contact portion into the liquid at an unexpected timing. It is also considered that foreign matter contained in the liquid accumulates in a region where the fluidity of the liquid is low and flows downstream together with the liquid at an unexpected timing.

The uneven surface 72 of the chemical liquid flow passage 31x is a surface in contact with the tip 72d of the convex portion 72h in a state where water such as a chemical liquid is separated from the bottom 72b of the concave portion 72u. Therefore, a contact area between the water and the uneven surface 72 can be reduced as compared with the case where the water is in contact with the bottom 72b of the concave portion 72u. Further, since water does not come into contact with or hardly comes into contact with the bottom 72b of the concave portion 72u, a region where water comes into contact with the uneven surface 72 can be limited. Since the range to be cleaned is thereby narrowed, the cleaning time can be shortened. Further, when a contact area between water and the chemical liquid flow passage 31x decreases, since the amount of impurities eluted into water from the chemical liquid flow passage 31x per unit time decreases, the concentration of impurities in water can be reduced. Since the foreign matter transferred from the water to the uneven surface 72 also decreases, the concentration of the foreign matter in the water can be reduced even when such foreign matter is peeled off from the uneven surface 72.

The mirror surface 71 of the solvent flow passage 33x is a surface having a reduced contact area with the organic solvent. That is, when comparing the case where the inner surface 33y of the solvent flow passage 33x is the mirror surface 71 as shown in Fig. 6 with the case where the inner surface is a rough surface as shown in Fig. 7, a contact area between the organic solvent and the solvent flow passage 33x is smaller when the inner surface 33y of the solvent flow passage 33x is the mirror surface 71. When the contact area between the organic solvent and the solvent flow passage 33x decreases, since the amount of impurities eluted from the solvent flow passage 33x into the organic solvent per unit time decreases, the concentration of impurities in the organic solvent can be reduced. Further, as compared with a case where the inner surface 33y of the solvent flow passage 33x is a rough surface, foreign matter contained in the organic solvent is less likely to adhere to the solvent flow passage 33x, and foreign matter transferred from the organic solvent to the solvent flow passage 33x is reduced. Therefore, even when the foreign matter adhering to the solvent flow passage 33x is peeled off, the concentration of the foreign matter in the organic solvent can be reduced.

Next, a flow of liquid in a bent portion 74 of the chemical liquid flow passage 31x shall be described.

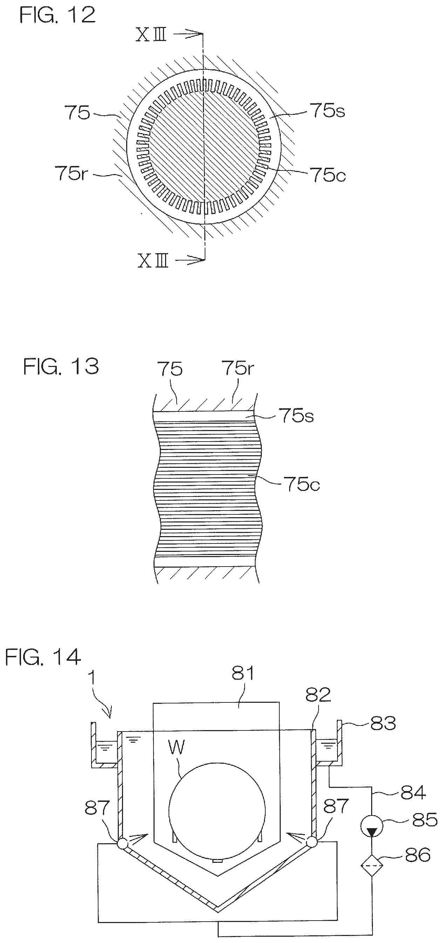

FIG. 10 is a schematic view showing an example of a cross section of the bent portion 74 of the chemical liquid piping 31p. FIG. 11 is a schematic view showing an example of a cross section of the bent portion 74 taken along line XI-XI shown in FIG. 10. FIG. 12 is a schematic view showing an example of a cross section of a mold 75 for manufacturing the chemical liquid piping 31p. FIG. 13 is a schematic view showing an example of a cross section of the mold 75 taken along line XIII-XIII shown in FIG. 12.

As shown in FIG. 11, an inner peripheral surface of the chemical liquid piping 31p includes a striped surface 73 including a plurality of linear protrusions 73h and a plurality of linear grooves 73u forming a striped pattern extending in the axial direction of the chemical liquid piping 31p (the direction along a center line 31L of the chemical liquid piping 31p). The striped surface 73 is one form of the uneven surface 72 (see FIG. 8). The linear protrusion 73h is one form of the convex portion 72h (see FIG. 8), and the linear groove 73u is one form of the concave portion 72u (see FIG. 8).

The plurality of linear protrusions 73h are disposed at intervals in the circumferential direction of the chemical liquid piping 31p (the direction around the center line 31L of the chemical liquid piping 31p). The same applies to the plurality of linear grooves 73u. One each of the plurality of linear grooves 73u are formed between the two linear protrusions 73h closest to each other in the circumferential direction of the chemical liquid piping 31p. FIG. 11 shows an example in which the striped surface 73 has an endless shape surrounding the center line 31L of the chemical liquid piping 31p. Only a portion of the inner peripheral surface of the chemical liquid piping 31p in the circumferential direction of the chemical liquid piping 31p may be the striped surface 73.

The linear groove 73u and the linear protrusion 73h extend in a direction parallel to the center line 31L of the chemical liquid piping 31p. In a portion where the center line 31L of the chemical liquid piping 31p is linear, the linear groove 73u and the linear protrusion 73h are also linear. In a portion where the center line 31L of the chemical liquid piping 31p is curved, the linear groove 73u and the linear protrusion 73h are also curved. The width of the linear groove 73u is shorter than the length of the linear groove 73u. The width of the linear protrusion 73h is shorter than the length of the linear protrusion 73h. The width of the linear protrusion 73h may be equal to or may be different from the width of the linear groove 73u.

FIG. 12 and FIG. 13 show an example of a cross section of the mold 75 for manufacturing the chemical liquid piping 31p by melt extrusion which is one of extrusion molding. The mold 75 is a mold for molding a piping made of a resin such as the chemical liquid piping 31p. The mold 75 may be a mold for molding the molten piping material, called a die, or may be a mold for finishing the shape of the piping that has passed through the die, called a sizing mold. The mold 75 includes a core 75c for molding the inner peripheral surface of the piping and a ring 75r for molding an outer peripheral surface of the piping. FIG. 13 shows an outer appearance of the core 75c.

A material of the piping made of a resin such as the chemical liquid piping 31p is supplied to a cylindrical space 75s between the core 75c and the ring 75r and continuously extruded from the space 75s. The piping is thereby molded. At this time, irregularities having the same or substantially the same shape as the irregularities provided on an outer peripheral surface of the core 75c are formed on the inner peripheral surface of the piping. The striped surface 73 is thereby molded. The piping extruded from the mold 75 is linear. When the bent portion 74 is provided in the piping, the straight piping may be temporarily softened and bent by heating. When the piping has flexibility, the piping may be bent without heating.

FIG. 10 shows an example in which the bent portion 74 includes a linear upstream portion 74u, a linear downstream portion 74d inclined at a constant angle with respect to the upstream portion 74u, and an arc-shaped corner portion 74c extending from the upstream portion 74u to the downstream portion 74d. In this example, the bent portion 74 is bent by 90 degrees. In other words, the upstream portion 74u and the downstream portion 74d are disposed on two straight lines orthogonal to each other. The upstream portion 74u, the corner portion 74c, and the downstream portion 74d are all tubular. The linear groove 73u and the linear protrusion 73h of the striped surface 73 are bent at the bent portion 74.

A vortex-shaped curve in FIG. 10 represents a region where stagnation and/or retention of liquid occurs. Since the striped surface 73 is provided on an inner peripheral surface of the bent portion 74, a contact area between water and the bent portion 74 can be reduced, and a region where water is in contact with the bent portion 74 can be limited. Further, since a resistance applied to water from the inner peripheral surface of the bent portion 74 is reduced, a decrease in the speed of water in the bent portion 74 can be reduced, and a region where stagnation and/or retention occur can be reduced. Therefore, impurities and foreign matters accumulated in such a region can be reduced, and contaminants moving from the inner peripheral surface of the bent portion 74 to the water flowing in the bent portion 74 can be reduced.

Next, the effects of the present preferred embodiment shall be described.

In the present preferred embodiment, water is guided toward the substrate W by a water flow passage, and an organic solvent which is a liquid having a surface tension lower than that of water is guided toward the substrate W by the solvent flow passage 33x. The chemical liquid flow passage 31x and the rinse liquid flow passage are examples of the water flow passage, and the chemical liquid and the rinse liquid are examples of water. The water flow passage includes the uneven surface 72 in contact with the water. The solvent flow passage 33x includes the mirror surface 71 in contact with the organic solvent.

The uneven surface 72 of the chemical liquid flow passage 31x includes the concave portion 72u at least partially filled with air and the convex portion 72h in contact with water in contact with the air in the concave portion 72u. Since at least a portion of the concave portion 72u is filled with the air, a contact area between the water and the uneven surface 72 is reduced as compared with a case where the entire concave portion 72u is filled with the water. Further, since the water does not come into contact with or hardly comes into contact with the inner surface of concave portion 72u, it is possible to limit a region where water comes into contact with uneven surface 72. Since the range to be cleaned with the cleaning liquid is thereby narrowed, the cleaning time can be shortened.

The mirror surface 71 of the solvent flow passage 33x is a smooth surface in contact with the organic solvent. Since the surface tension of the organic solvent is low, even when the inner surface 33y of the solvent flow passage 33x is a rough surface, the organic solvent in the solvent flow passage 33x enters the groove of the rough surface. In this case, when a surface roughness of the rough surface decreases, the contact area between the organic solvent and the solvent flow passage 33x also decreases. When the surface roughness is extremely reduced, the rough surface becomes the mirror surface 71. Therefore, by providing the mirror surface 71 on the inner surface 33y of the solvent flow passage 33x, the range to be cleaned with the cleaning liquid can be narrowed as compared with the case where the inner surface 33y of the solvent flow passage 33x is a rough surface, and the cleaning time can be shortened.

In the present preferred embodiment, all or portion of the uneven surface 72 is made of fluororesin. The fluororesin is a material having high water repellency. Whether the droplet on the rough surface takes on the Wenzel state or the Cassie-Baxter state is affected by factors such as a surface tension of the liquid, a surface free energy of the rough surface (solid), and a surface property of the rough surface. By making the uneven surface 72 with a material having high water repellency, a state where at least a portion of the concave portion 72u is filled with air can be maintained. It is thereby possible to reduce the contact area between water and the uneven surface 72 while limiting the region where water is in contact with the uneven surface 72.

In the present preferred embodiment, the chemical liquid is guided from the chemical liquid tank 31t to the chemical liquid piping 31p. The chemical liquid tank 31t and the chemical liquid piping 31p correspond to a water tank and a water piping. The uneven surface 72 is provided on the inner surface of the chemical liquid tank 31t. The time during which the chemical liquid is in contact with the chemical liquid tank 31t is longer than the time during which the chemical liquid is in contact with the chemical liquid piping 31p. Therefore, by reducing a contact area between the chemical liquid and the chemical liquid tank 31t, it is possible to effectively reduce contaminants transferred from the chemical liquid tank 31t to the chemical liquid.

In the present preferred embodiment, the organic solvent is guided from the solvent tank 33t to the solvent piping 33p. The mirror surface 71 is provided on the inner surface of the solvent tank 33t. The time during which the organic solvent is in contact with the solvent tank 33t is longer than the time during which the organic solvent is in contact with the solvent piping 33p. Therefore, by reducing a contact area between the organic solvent and the solvent tank 33t, contaminants transferred from the solvent tank 33t to the organic solvent can be effectively reduced.

In the present preferred embodiment, the uneven surface 72 is provided on the inner surface of the bent portion 74 of the chemical liquid flow passage 31x, which is an example of a water flow passage. A region where the fluidity of the liquid is low (a region where stagnation and/or retention of the liquid occurs) may be generated in the bent portion 74. In such a case, it is considered that contaminants such as particles accumulate in the bent portion 74 and flow together with the chemical liquid at an unexpected timing. When the uneven surface 72 is provided on the inner surface of the bent portion 74, since a resistance applied to the chemical liquid from the inner surface of the bent portion 74 is reduced, a decrease in the speed of chemical liquid at the bent portion 74 can be reduced, and a region where stagnation and/or retention of the chemical liquid occur can be reduced. Therefore, impurities and foreign matters accumulated in such a region can be reduced, and contaminants moving from the inner surface of the bent portion 74 to the chemical liquid flowing in the bent portion 74 can be reduced.

Next, another preferred embodiment shall be described.

Instead of providing the uneven surface 72 or the striped surface 73 on the chemical liquid tank 31t and the bent portion 74, the uneven surface 72 or the striped surface 73 may be provided only on the chemical liquid tank 31t or only on the bent portion 74.

The striped surface 73 may be provided on a portion of the inner surface 31y of the chemical liquid flow passage 31x other than an inner peripheral surface of the chemical liquid piping 31p, such as the inner surface of the chemical liquid tank 31t. In this case, the directions of the plurality of linear protrusions 73h and the plurality of linear grooves 73u does not have to be parallel to the flowing direction of the chemical liquid.

The substrate processing apparatus 1 is not restricted to an apparatus that processes substrates W of disk shape and may instead be an apparatus that processes substrates W of polygonal shape. The substrate processing apparatus 1 may be an apparatus of the batch type that processes a plurality of substrates W in a batch.

As shown in FIG. 14, the batch-type substrate processing apparatus 1 includes a lifter 81 that is raised and lowered between an upper position and a lower position while holding the plurality of substrates W, and an inner tank 82 that stores a processing liquid in which the plurality of substrates W held by the lifter 81 positioned at the lower position are immersed. The batch-type substrate processing apparatus 1 further includes a nozzle 87 that supplies a processing liquid into the inner tank 82, an outer tank 83 that stores the processing liquid overflowing from the inner tank 82, a circulation piping 84 that guides the processing liquid from the outer tank 83 to the nozzle 87, a pump 85 that feeds the processing liquid from the outer tank 83 to the nozzle 87 through the circulation piping 84, and a filter 86 that removes foreign matter from the processing liquid flowing through the circulation piping 84. The lifter 81 corresponds to a substrate holder.

The processing liquid supplied into the inner tank 82 may be water such as a chemical liquid or a rinse liquid, or may be an organic solvent. The outer tank 83 corresponds to the start position of the water flow passage or the solvent flow passage 33x. The inner tank 82 corresponds to the goal position of the water flow passage or the solvent flow passage 33x. When the processing liquid is water, the uneven surface 72 is provided on the inner surface of at least one of the inner tank 82, the outer tank 83, the circulation piping 84, the pump 85, the filter 86, and the nozzle 87. When the processing liquid is an organic solvent, a mirror surface 71 is provided on an inner surface of at least one of the inner tank 82, the outer tank 83, the circulation piping 84, the pump 85, the filter 86, and the nozzle 87.

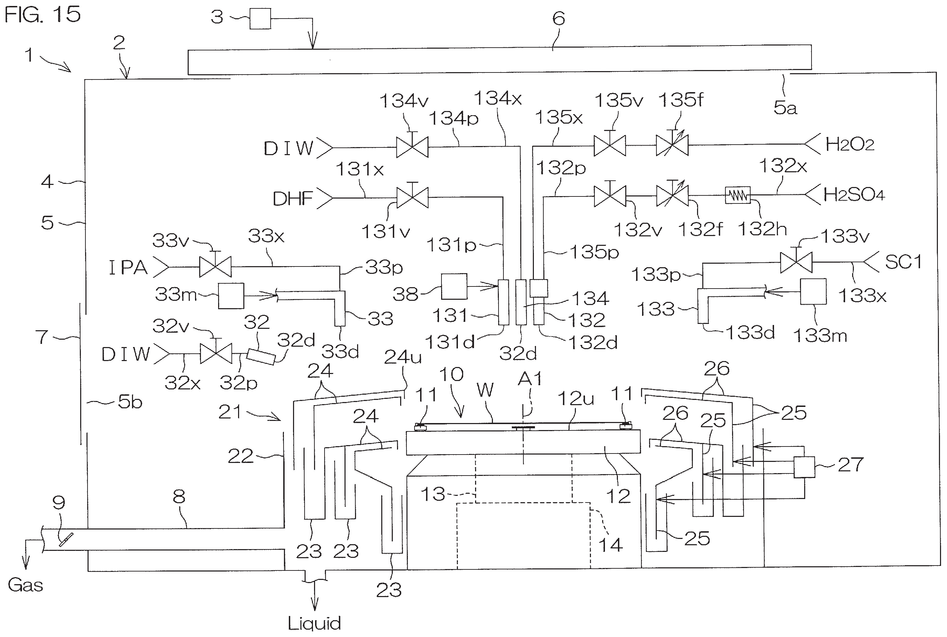

FIG. 15 is a schematic view showing another configuration example of the processing unit 2, and shows a configuration in which an interior of the processing unit 2 is viewed horizontally as in FIG. 2. In FIG. 15, the corresponding parts in FIG. 2 are shown by attaching the same reference signs, and the configurations and operations are substantially the same as those in FIG. 2, and thus the description thereof shall be omitted.

In this configuration example, since the contents of a processing liquid supply system and the substrate processing are different from those in the configuration example of FIG. 2, these shall be mainly described.

The processing unit 2 includes a plurality of nozzles that discharge the processing fluid toward the substrate W held by the spin chuck 10. The plurality of nozzles includes a first chemical liquid nozzle 131 that discharges a first chemical liquid toward the upper surface of the substrate W, a second chemical liquid nozzle 132 that discharges a second chemical liquid toward the upper surface of the substrate W, and a rinse liquid nozzle 134 (a first rinse liquid nozzle) that discharges a rinse liquid toward the upper surface of the substrate W. Also, the plurality of nozzles include a third chemical liquid nozzle 133 that discharges a third chemical liquid toward the upper surface of the substrate W. FIG. 15 shows a case where the first chemical liquid is DHF (dilute hydrofluoric acid), which is an example of an acid, the second chemical liquid is a sulfuric acid-hydrogen peroxide mixture (known as SPM) that has the effect of removing organic matter such as resist, and the third chemical liquid is an ammonia-hydrogen peroxide mixture (known as SC1: Standard Clean 1), which is an example of an alkali. Also, FIG. 15 shows a case where the rinse liquid discharged from the rinse liquid nozzle 134 is DIW (deionized water). As described above, the rinse liquid may be other than DIW.

The plurality of nozzles further include the rinse liquid nozzle 32 (a second rinse liquid nozzle) that discharges the rinse liquid toward the upper surface of the substrate W, and the solvent nozzle 33 that discharges the organic solvent toward the upper surface of the substrate W, as in the configuration example of FIG. 2. FIG. 15 shows an example in which the rinse liquid nozzle 32 discharges DIW and the solvent nozzle 33 discharges IPA (isopropyl alcohol) as in the case of FIG. 2. The type of the rinse liquid discharged from the rinse liquid nozzle 32 and the type of the organic solvent discharged from the solvent nozzle 33 are as described above. Also, the configuration of a rinse liquid supply system to the rinse liquid nozzle 32 and the configuration of an organic solvent supply system to the solvent nozzle 33 are also as described above, and are the same as the case of the configuration example of FIG. 2.

Although not shown in FIG. 15, a shielding plate opposing the upper surface of the substrate W held by the spin chuck 10 from above may be provided. In this case, the rinse liquid nozzle 32 and the solvent nozzle 33 may be attached to the shielding plate and disposed such as to discharge the liquid from the center of the shielding plate toward the center of the substrate W.

The first chemical liquid nozzle 131, the second chemical liquid nozzle 132, and the rinse liquid nozzle 134 are connected to a nozzle moving unit 38. The nozzle moving unit 38 changes a liquid landing position (that is, the distance from the rotational axis A1 to the liquid landing position) of the liquid discharged from the first chemical liquid nozzle 131, the second chemical liquid nozzle 132, and the rinse liquid nozzle 134 on the substrate W in the radial direction (the radial direction around the rotational axis A1). The first chemical liquid nozzle 131, the second chemical liquid nozzle 132, and the rinse liquid nozzle 134 thereby have a form of a scan nozzle in which the liquid landing position changes in the radial direction on the substrate W. For example, the nozzle moving unit 38 may be a swinging unit that swings the first chemical liquid nozzle 131, the second chemical liquid nozzle 132, and the rinse liquid nozzle 134 along an arc-shaped horizontal path passing near the rotational axis A1. The third chemical liquid nozzle 133 is connected to a nozzle moving unit 133m. The nozzle moving unit 133m changes the liquid landing position in the radial direction on the substrate W of the liquid discharged from the third chemical liquid nozzle 133. The third chemical liquid nozzle 133 thereby has a form of a scan nozzle in which the liquid landing position changes in the radial direction on the substrate W. For example, the nozzle moving unit 133m may be a swinging unit that turns the third chemical liquid nozzle 133 along an arc-shaped horizontal path passing near the rotational axis A. One or more of the first chemical liquid nozzle 131, the second chemical liquid nozzle 132, the third chemical liquid nozzle 133, and the rinse liquid nozzle 134 may be a fixed nozzle fixed in the processing unit 2.

The first chemical liquid nozzle 131 is connected to a first chemical liquid piping 131p that guides the DHF toward the first chemical liquid nozzle 131. The rinse liquid nozzle 134 is connected to a rinse liquid piping 134p that guides pure water toward the rinse liquid nozzle 134. When a first chemical liquid valve 131v interposed in the first chemical liquid piping 131p is opened, DHF is supplied from the first chemical liquid piping 131p to the first chemical liquid nozzle 131 and continuously discharged downward from the first chemical liquid nozzle 131. When a rinse liquid valve 134v interposed in the rinse liquid piping 134p is opened, pure water is supplied from the rinse liquid piping 134p to the rinse liquid nozzle 134 and continuously discharged downward from the rinse liquid nozzle 134. The temperature of the pure water discharged from the rinse liquid nozzle 134 may be room temperature or may be higher than room temperature.

The second chemical liquid nozzle 132 is connected to a sulfuric acid piping 132p that guides sulfuric acid toward the second chemical liquid nozzle 132 and a hydrogen peroxide water piping 135p that guides hydrogen peroxide water toward the second chemical liquid nozzle 132. A sulfuric acid valve 132v and a flow control valve 132f are interposed in the sulfuric acid piping 132p. A hydrogen peroxide water valve 135v and a flow control valve 135f are interposed in the hydrogen peroxide water piping 135p.

When the sulfuric acid valve 132v is opened, sulfuric acid is supplied from the sulfuric acid piping 132p to the second chemical liquid nozzle 132 at a flow rate corresponding to the opening degree of the flow control valve 132f. When the hydrogen peroxide water valve 135v is opened, the hydrogen peroxide water is supplied from the hydrogen peroxide water piping 135p to the second chemical liquid nozzle 132 at a flow rate corresponding to the opening degree of the flow control valve 135f. When the sulfuric acid valve 132v and the hydrogen peroxide water valve 135v are opened, the sulfuric acid and the hydrogen peroxide water become mixed together and SPM is formed. Then, the SPM is continuously discharged downward from the second chemical liquid nozzle 132 toward the upper surface of the substrate W.

The flow rate of the SPM discharged from the second chemical liquid nozzle 132 and the mixing ratio of sulfuric acid and hydrogen peroxide water (the ratio of the flow rate of sulfuric acid to the flow rate of hydrogen peroxide water) are changed by the flow control valve 132f and the flow control valve 135f. The temperature of the SPM discharged from the second chemical liquid nozzle 132 is changed by the mixing ratio of the sulfuric acid and the hydrogen peroxide water, the temperature of the sulfuric acid before mixing, and the temperature of the hydrogen peroxide water before mixing.

The mixing ratio of the sulfuric acid and the hydrogen peroxide water (ratio of the flow rate of the sulfuric acid to the flow rate of the hydrogen peroxide water) is, for example, not less than 2. When the sulfuric acid and the hydrogen peroxide water are mixed together, SPM of high temperature is formed due to heat of dilution of the sulfuric acid. The temperature of the SPM discharged from the second chemical liquid nozzle 132 is, for example, higher than 100°C. The temperature of the sulfuric acid before being mixed with the hydrogen peroxide water is higher than room temperature, for example, higher than 100°C. The substrate processing apparatus 1 includes a heater 34h that heats sulfuric acid supplied to the second chemical liquid nozzle 132. The temperature of the hydrogen peroxide water before being mixed with sulfuric acid is, for example, room temperature (for example, 20 to 30°C). The temperature of the hydrogen peroxide water before being mixed with the sulfuric acid may instead be higher than room temperature.

The third chemical liquid nozzle 133 is connected to a third chemical liquid piping 133p that guides the SC1 toward the third chemical liquid nozzle 133. When a third chemical liquid valve 133v interposed in the third chemical liquid piping 133p is opened, SC1 is supplied from the third chemical liquid piping 133p to the third chemical liquid nozzle 133 and continuously discharged downward from the third chemical liquid nozzle 133.

Next, an example of processing of the substrate W will be described.

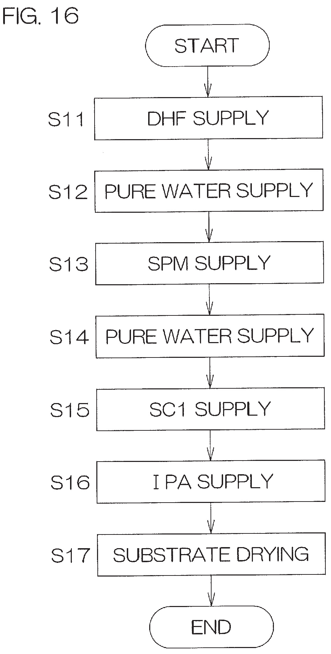

FIG. 16 is a process diagram for explaining an example of processing the substrates W performed by the substrate processing apparatus 1. FIG. 16 shows an example in which these processing liquids are supplied to the substrate W in the order of DHF, pure water, SPM, pure water, SC1, and IPA.

The substrate W to be processed is, for example, a semiconductor wafer such as a silicon wafer. The front surface of the substrate W corresponds to a device forming surface on which a device, such as a transistor, capacitor, etc., is formed. In the following, an example of resist removal of removing a mask of resist that has become unnecessary from the substrate W by supplying the SPM that is one example of a resist removing liquid and a resist peeling liquid to the upper surface of the substrate W shall be described. The process on the substrate W may instead be that other than resist removal.

When the substrate W is processed, the indexer robot IR carries out the substrate W from the carrier CA on any one of the load ports LP. The center robot CR carries the substrate W, that have been carried out by the indexer robot IR, into any one of the processing units 2 and places the substrate W on the spin chuck 10. Thereafter, the plurality of chuck pins 11 are horizontally pressed against the end surface of the substrate W, and the spin motor 14 starts to rotate. The rotation of the substrate W is thereby started.

When the rotation of the substrate W is started, the first chemical liquid valve 131v is opened, and the first chemical liquid nozzle 131 discharges DHF toward the upper surface of the rotating substrate W. The entire upper surface of the substrate W is thereby processed by DHF (step S11: an example of a water supplying step). This process may be a pre-cleaning process of removing foreign matter by light etching (for example, etching of a natural oxide film) the surface of the substrate W. When the first chemical liquid nozzle 131 is discharging the DHF, the nozzle moving unit 38 may move the first chemical liquid nozzle 131 such that the collision position of the DHF with respect to the upper surface of the substrate W passes through the central portion and the outer peripheral portion, or may stop the first chemical liquid nozzle 131 such that the collision position stops at the central portion. Whether or not to move the collision position is the same for other processing liquids (pure water, SPM, SC1, IPA).

When a predetermined time elapses after the first chemical liquid valve 131v is opened, the first chemical liquid valve 131v is closed and the rinse liquid valve 134v is opened. In response to this, the rinse liquid nozzle 134 discharges pure water, which is an example of the rinse liquid, toward the upper surface of the rotating substrate W. DHF on the substrate W is thereby replaced with pure water, and DHF is removed from the entire region of the upper surface of the substrate W (step S12: an example of a water supplying step). Before the rinsing with pure water, a solvent rinsing step (an example of a solvent supplying step) of supplying IPA from the solvent nozzle 33 to the substrate W may be performed.

After the pure water rinsing for a predetermined time, the rinse liquid valve 134v is closed. Then, the SPM process is started (step S13: an example of a high-temperature chemical liquid supplying step). That is, the sulfuric acid valve 132v and the hydrogen peroxide water valve 135v are opened, sulfuric acid and hydrogen peroxide water are thereby mixed in the second chemical liquid nozzle 132 and SPM is formed, and the SPM is discharged from the second chemical liquid nozzle 132 toward the substrate W. The entire upper surface of the substrate W is thereby processed by the SPM. By this SPM process, the resist on the upper surface of the substrate W is peeled off and removed to the outside of the substrate W.

After a predetermined time, the sulfuric acid valve 132v and the hydrogen peroxide water valve 135v are closed, and the SPM process ends. Next, the rinse liquid valve 134v is opened. In response to this, the rinse liquid nozzle 134 discharges pure water, which is an example of the rinse liquid, toward the upper surface of the rotating substrate W. The SPM on the substrate W is thereby replaced with pure water, and the SPM is removed from the entire upper surface of the substrate W (step S14: an example of a water supplying step).

After the pure water rinsing for a predetermined time, the rinse liquid valve 134v is closed. Then, a chemical liquid process using SC1 is started (step S15). That is, the third chemical liquid valve 133v is opened, and the third chemical liquid nozzle 133 discharges SC1 toward the upper surface of the rotating substrate W. The entire upper surface of the substrate W is thereby processed by SC1. This process may be a residue removing process for removing residues remaining on the substrate after the SPM process and the rinse process.

After a predetermined time, the third chemical liquid valve 133v is closed, and the chemical liquid process using SC1 ends. Next, the solvent valve 33v is opened. In response to this, the solvent nozzle 33 discharges IPA, which is an example of an organic solvent, toward the upper surface of the rotating substrate W. SC1 on the substrate W is thereby replaced with IPA, and a liquid film of IPA covering the entire upper surface of the substrate W is formed (step S16: an example of a solvent supplying step). Thereafter, the solvent valve 33v is closed. It is noted that, after the chemical liquid process by SC1, a pure water rinsing process may be performed before the start of supply of IPA.

When the solvent valve 33v is closed, the spin motor 14 rotates the substrate W held by the plurality of chuck pins 11 at a high rotation speed (for example, several thousand rpm). The liquid is thereby removed from the substrate W, and the substrate W is dried (step S17). After the substrate W is dried, the spin motor 14 is stopped, and the plurality of chuck pins 11 are separated from the end surface of the substrate W. The rotation of the substrate W is thereby stopped, and the holding of the substrate W is released. Thereafter, the center robot CR carries out the substrate W from the processing unit 2. The indexer robot IR carries the substrate W, that have been carried out by the center robot CR, into the carrier CA on one of the load ports LP.

Thus, a single substrate W is processed with a processing liquid such as a chemical liquid or a rinse liquid. The controller 3 causes the substrate processing apparatus 1 to repeat the above series of operations by controlling the indexer robot IR, etc. The plurality of substrates W are thereby processed one by one.

Next, the processing liquid supply system shall be described.

The composition ratio of HF/H2O in DHF (dilute hydrofluoric acid) as the first chemical liquid is approximately 1/1000 to 1/100 in terms of volume ratio, and DHF is a liquid having a surface tension equal to or substantially equal to a surface tension of water (H2O), and is a liquid that can be handled as an example of water. Therefore, a path through which the DHF passes until reaching a discharge port 131d of the first chemical liquid nozzle 131 is one chemical liquid flow passage 131x continuous from a start position to a goal position, and is an example of a water flow passage. And, the structure of the chemical liquid flow passage 131x through which the DHF passes is substantially the same as the structure of the chemical liquid flow passage 31x described with reference to FIG. 5A, etc. Therefore, the above description regarding the structure of the chemical liquid flow passage 31x is cited by replacing "chemical liquid" with "DHF," and the description of the flow passage structure of the chemical liquid flow passage 131x through which the DHF passes is substituted.

Also, SC1 (ammonia-hydrogen peroxide mixture) which is the third chemical liquid is, for example, a liquid having a composition ratio of 1 for ammonia water (28 to 30 wt%), 1 for hydrogen peroxide water (30 wt%), and 5 for water in terms of volume ratio, and having a surface tension equal to or substantially equal to a surface tension of water (H2O), and is a liquid that can be handled as an example of water. Therefore, a path through which SC1 passes until reaching a discharge port 133d of the third chemical liquid nozzle 133 is one chemical liquid flow passage 133x continuous from a start position to a goal position, and is an example of a water flow passage. And, the structure of the chemical liquid flow passage 133x through which SC1 passes is substantially the same as the structure of the chemical liquid flow passage 31x described with reference to FIG. 5A, etc. Therefore, the above description regarding the structure of the chemical liquid flow passage 31x is cited by replacing "chemical liquid" with "SC1," and the description of the flow passage structure of the chemical liquid flow passage 133x through which SC1 passes is substituted.

Next, a path through which the rinse liquid passes until being discharged from a discharge port 134d of the rinse liquid nozzle 134 corresponds to one rinse liquid flow passage 134x continuous from a start position to a goal position. The structure of the rinse liquid flow passage 134x is the same as the case of the rinse liquid flow passage described with respect to the rinse liquid nozzle 32 in the configuration example of the processing unit 2 of FIG. 2, and thus the description thereof shall be omitted.

The structure of a rinse liquid flow passage 32x, which is a path through which the rinse liquid passes before being discharged from the discharge port 32d of the rinse liquid nozzle 32, is the same as the case of the configuration example of the processing unit 2 in FIG. 2. Also, the structure of the solvent flow passage 33x, which is a path through which the organic solvent passes until being discharged from the discharge port 33d of the solvent nozzle 33, is also the same as the case of the configuration example of the processing unit 2 in FIG. 2.

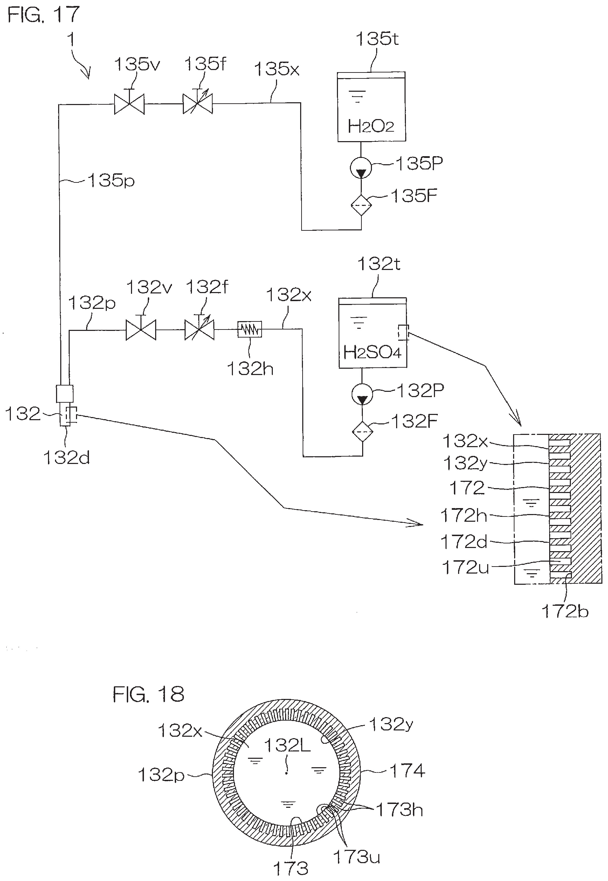

FIG. 17 is a schematic view of a chemical liquid supply system that supplies the SPM as the second chemical liquid to the substrate W. The substrate processing apparatus 1 includes a sulfuric acid tank 132t that stores sulfuric acid (typically concentrated sulfuric acid) and a hydrogen peroxide water tank 135t that stores hydrogen peroxide water. The sulfuric acid stored in the sulfuric acid tank 132t is, to be accurate, a sulfuric-acid-containing liquid containing sulfuric acid. For example, the SPM used for processing the substrate W may be collected, subjected to a necessary regeneration process, then introduced into the sulfuric acid tank 132t, and used as sulfuric acid (sulfuric-acid-containing liquid). An upstream end of the sulfuric acid piping 132p is connected to the sulfuric acid tank 132t, and an upstream end of the hydrogen peroxide water piping 135p is connected to the hydrogen peroxide water tank 135t. Downstream ends of the sulfuric acid piping 132p and the hydrogen peroxide water piping 135p are connected to the second chemical liquid nozzle 132. The sulfuric acid piping 132p is provided with a sulfuric acid pump 132P for feeding sulfuric acid in the sulfuric acid tank 132t toward the second chemical liquid nozzle 132, and a sulfuric acid filter 132F for removing foreign matter from sulfuric acid fed from the sulfuric acid tank 132t. In the hydrogen peroxide water piping 135p, a pump 135P that feeds the hydrogen peroxide water in the hydrogen peroxide water tank 135t toward the second chemical liquid nozzle 132 and a filter 135F that removes foreign matter from the hydrogen peroxide water fed from the hydrogen peroxide water tank 135t are interposed.

The hydrogen peroxide water supplied to the second chemical liquid nozzle 132 and mixed with sulfuric acid is a liquid having a surface tension close to that of water (H2O), and in designing the flow passage structure, may be used as an example of water . Therefore, a path through which the hydrogen peroxide water passes until reaching the second chemical liquid nozzle 132 is one chemical liquid flow passage 135x continuous from a start position to a goal position, and is an example of a water flow passage. And, the structure of the chemical liquid flow passage 135x through which the hydrogen peroxide water passes is substantially the same as the structure of the chemical liquid flow passage 31x described with reference to FIG. 5A, etc. Therefore, the above description regarding the structure of the chemical liquid flow passage 31x is cited by replacing "chemical liquid" with "hydrogen peroxide water," and the description of the flow passage structure of the chemical liquid flow passage 135x of the hydrogen peroxide water is substituted.

On the other hand, the SPM formed by mixing sulfuric acid (concentrated sulfuric acid) supplied to the second chemical liquid nozzle 132 and mixed with hydrogen peroxide water, sulfuric acid, and hydrogen peroxide water is an example of a high-temperature chemical liquid having a temperature higher than room temperature. The behavior of sulfuric acid (particularly, concentrated sulfuric acid) and SPM as liquids is difficult to be equated with that of water, but there is a possibility that impurities (particularly, a plasticizer) in a resin material dissolve into a chemical liquid, particularly in a case where a high-temperature chemical liquid flow passage in contact with sulfuric acid and SPM as a high-temperature chemical liquid is made of a resin material such as a fluororesin. Therefore, as with the water flow passage described above, the high-temperature chemical liquid flow passage is preferably designed to reduce the contact area with the chemical liquid as much as possible.

A path through which the high-temperature chemical liquid (sulfuric acid or SPM) passes before being discharged from a discharge port 132d of the second chemical liquid nozzle 132 corresponds to one high-temperature chemical liquid flow passage 132x continuous from a start position to a goal position. The sulfuric acid tank 132t is an example of a high-temperature chemical liquid tank, and corresponds to the start position of the high-temperature chemical liquid flow passage 132x. The second chemical liquid nozzle 132 is an example of a high-temperature chemical liquid nozzle, and the discharge port 132d corresponds to the goal position of the high-temperature chemical liquid flow passage 132x.

The high-temperature chemical liquid flow passage 132x includes the second chemical liquid nozzle 132 provided with the discharge port 132d that discharges the SPM, and the sulfuric acid piping 132p that guides sulfuric acid toward the second chemical liquid nozzle 132. The sulfuric acid piping 132p is an example of a high-temperature chemical liquid piping. The high-temperature chemical liquid flow passage 132x may further include a fluid device other than the second chemical liquid nozzle 132 and the sulfuric acid piping 132p. In this example, the high-temperature chemical liquid flow passage 132x includes the sulfuric acid valve 132v, the flow control valve 132f, the sulfuric acid tank 132t, the sulfuric acid pump 132P, the sulfuric acid filter 132F, and a heater 132h. In place of or in addition to at least one of these, the high-temperature chemical liquid flow passage 132x may further include at least one of a circulation piping that circulates sulfuric acid from the downstream of the heater 132h to the sulfuric acid tank 132t, a flow meter that measures the flow rate of sulfuric acid supplied to the second chemical liquid nozzle 132, a joint that connects two or more pipings, and a manifold that connects three or more pipings.

The high-temperature chemical liquid flow passage 132x includes an internal space in which a flowing or stationary high-temperature chemical liquid (sulfuric acid or SPM) is disposed, and a cylindrical inner surface 132y surrounding the entire circumference of the internal space. The internal space of the high-temperature chemical liquid flow passage 132x is a sealed space opened only at the goal position of the high-temperature chemical liquid flow passage 132x. In other words, the internal space of the high-temperature chemical liquid flow passage 132x is in contact with the space outside the high-temperature chemical liquid flow passage 132x only at the goal position of the high-temperature chemical liquid flow passage 132x.

The inner surface 132y of the high-temperature chemical liquid flow passage 132x is made of a resin such as a fluororesin. The fluororesin may be PTFE (polytetrafluoroethylene) or PFA (perfluoroalkoxy alkane), or may be other than these. The entire inner surface 132y of the high-temperature chemical liquid flow passage 132x may be made of the same material, or a portion of the inner surface 132y of the high-temperature chemical liquid flow passage 132x may be made of a material different from the remaining portion of the inner surface 132y of the high-temperature chemical liquid flow passage 132x.

As shown in an enlarged manner on the right side of FIG. 17, the inner surface 132y of the high-temperature chemical liquid flow passage 132x includes an uneven surface 172 that is in contact with the chemical liquid (sulfuric acid or SPM) in the high-temperature chemical liquid flow passage 132x. The uneven surface 172 is a rough surface having a surface roughness larger than that of the mirror surface 71 (see FIG. 5B).

The entire inner surface 132y of the high-temperature chemical liquid flow passage 132x may be the uneven surface 172, or only a portion of the inner surface 132y of the high-temperature chemical liquid flow passage 132x may be the uneven surface 172. FIG. 17 shows an example in which all or portion of the inner surfaces of the sulfuric acid tank 132t and the second chemical liquid nozzle 132 are the uneven surface 172.

The uneven surface 172 is a water repellent surface subjected to a water repellent finishing as in the case of the chemical liquid flow passage 31x described above, and thereby is a surface which has a large contact angle of sulfuric acid and has an accordingly small contact area with sulfuric acid . The water repellent finishing may be at least one of cutting, laser processing, plastic processing, extrusion molding, blasting, and etching, or may be other than these.

As shown in FIG. 17, the uneven surface 172 is a solid surface provided with a plurality of concave portions 172u and a plurality of convex portions 172h. The concave portion 172u is recessed from a tip 172d of the convex portion 172h. The convex portion 172h protrudes from a bottom 172b of the concave portion 172u. The bottom 172b of the concave portion 172u corresponds to a proximal portion of the convex portion 172h. The tip 172d of the convex portion 172h corresponds to an opening end of the concave portion 172u. The tips 172d of the two adjacent convex portions 172h form an inlet of the concave portion 172u positioned therebetween.

The convex portion 172h may have a linear shape in which the depth is longer than the width, a point shape in which the depth is equal to or substantially equal to the width, or may be other than these. The same applies to the concave portion 172u. The cross section of the convex portion 172h may be any one of a rectangle, a square, a triangle, an inverted triangle, a trapezoid, an inverted trapezoid, and a semicircle, or may be other than these. The same applies to the cross section of the concave portion 172u. FIG. 17 shows an example in which the cross sections of the convex portion 172h and the concave portion 172u are rectangular. The height (length in the left-right direction in FIG. 17) of the convex portion 172h may be uniform or may be non-uniform. The same applies to the depth of the concave portion 172u. The height of the convex portion 172h may be equal to or may be different from the width of the convex portion 172h (the length in the vertical direction in FIG. 17). The depth of the concave portion 172u may be equal to or may be different from the width of the concave portion 172u.

The water contact angle with respect to the uneven surface 172 may be not less than 119 degrees, and preferably not less than 150 degrees.

The inner surface 132y of the high-temperature chemical liquid flow passage 132x is a liquid contact portion in contact with liquid. The liquid contact portion is made of a resin such as a fluororesin. As described with reference to FIG. 9, the fluororesin may contain impurities (small black circles in FIG. 9) different from the fluororesin in some cases. An example of the impurity is a plasticizer. Such impurities may be eluted from the liquid contact portion into the high-temperature chemical liquid in some cases. In order to prevent this, when the substrate processing apparatus 1 is started up, that is, when preparing to use the substrate processing apparatus 1 in a plant such as a semiconductor manufacturing plant, the liquid contact portion is cleaned with a cleaning liquid. Such cleaning is also referred to as flushing.

However, even after the cleaning is performed, the impurities such as the plasticizer move from an interior of the fluororesin to the surface of the fluororesin. When a period during which the substrate processing apparatus 1 does not process the substrate W (a period during which the liquid does not flow along the liquid contact portion) is long, a large amount of impurities are accumulated in the liquid contact portion, and when the processing of the substrate W is resumed, the impurities are eluted from the liquid contact portion into the liquid. Therefore, when the period during which the substrate processing apparatus 1 does not process the substrate W is long, it is necessary to perform cleaning before resuming the processing of the substrate W.

When cleaning is performed, not only the cleaning liquid but also energy such as electric power is used. When the time required for cleaning is long, the energy consumption amount and the use amount of the cleaning liquid increase. The same applies to a case where the number of times of cleaning is large. In order to reduce the cost required for cleaning and a load on the environment, it is desirable to reduce the time required for cleaning and the number of times of cleaning.

On the other hand, even when the substrate processing apparatus 1 continues to process the substrate W or even when the period during which the substrate processing apparatus 1 does not process the substrate W is short, contaminants such as impurities may be eluted into the liquid from the liquid contact portion in some cases. For example, in a region where the fluidity of the liquid is low (a region where stagnation and/or retention of the liquid occurs), it is considered that many impurities are accumulated in the liquid contact portion and are eluted from the liquid contact portion into the liquid at an unexpected timing. It is also considered that foreign matter contained in the liquid accumulates in a region where the fluidity of the liquid is low and flows downstream together with the liquid at an unexpected timing.

The uneven surface 172 of the high-temperature chemical liquid flow passage 132x is a surface in contact with the tip 172d of the convex portion 172h in a state where the high-temperature chemical liquid is separated from the bottom 172b of the concave portion 172u. Therefore, a contact area between the high-temperature chemical liquid and the uneven surface 172 can be reduced as compared with the case where the high-temperature chemical liquid is in contact with the bottom 172b of the concave portion 172u. Further, since the high-temperature chemical liquid does not come into contact with or hardly comes into contact with the bottom 172b of the concave portion 172u, a region where the high-temperature chemical liquid comes into contact with the uneven surface 172 can be limited. Since the range to be cleaned is thereby narrowed, the cleaning time can be shortened. Further, when a contact area between the high-temperature chemical liquid and the high-temperature chemical liquid flow passage 132x is reduced, since the amount of impurities eluted from the high-temperature chemical liquid flow passage 132x into the high-temperature chemical liquid per unit time decreases, the concentration of impurities in the high-temperature chemical liquid can be reduced. Since the foreign matter transferred from the high-temperature chemical liquid to the uneven surface 172 also decreases, the concentration of the foreign matter in the high-temperature chemical liquid can be reduced even when such foreign matter is peeled off from the uneven surface 172.

FIG. 18 is a sectional view showing a structural example of a cross section of the sulfuric acid piping 132p which is an example of a high-temperature chemical liquid piping. The inner peripheral surface of the sulfuric acid piping 132p includes a striped surface 173 including a plurality of linear protrusions 173h and a plurality of linear grooves 173u forming a striped pattern extending in the axial direction of the sulfuric acid piping 132p (the direction along the center line 132L of the sulfuric acid piping 132p). The striped surface 173 is one form of the uneven surface 172 (see FIG. 17). The linear protrusion 173h is one form of the convex portion 172h (see FIG. 17), and the linear groove 173u is one form of the concave portion 172u (see FIG. 17). Preferably, the inner surface of the sulfuric acid piping 132p, preferably the entire section, or at least a portion of the section including the bent portion, is made into such a striped surface 173.

The plurality of linear protrusions 173h are disposed at intervals in the circumferential direction of the sulfuric acid piping 132p (the direction around the center line 132L of the sulfuric acid piping 132p). The same applies to the plurality of linear grooves 173u. One each of the plurality of linear grooves 173u is formed between the two linear protrusions 173h closest to each other in the circumferential direction of the sulfuric acid piping 132p. FIG. 18 shows an example in which the striped surface 173 has an endless shape surrounding the center line 132L of the sulfuric acid piping 132p. Only a portion of the inner peripheral surface of the sulfuric acid piping 132p in the circumferential direction of the sulfuric acid piping 132p may be the striped surface 173.

The linear groove 173u and the linear protrusion 173h extend in a direction parallel to the center line 132L of the sulfuric acid piping 132p. In a portion where the center line 132L of the sulfuric acid piping 132p is linear, the linear groove 173u and the linear protrusion 173h are also linear. In a portion where the center line 132L of the sulfuric acid piping 132p is curved, the linear groove 173u and the linear protrusion 173h are also curved. The width of the linear groove 173u is shorter than the length of the linear groove 173u. The width of the linear protrusion 173h is shorter than the length of the linear protrusion 173h. The width of the linear protrusion 173h may be equal to or may be different from the width of the linear groove 173u.

Next, effects of the present preferred embodiment including the processing unit 2 described with reference to FIG. 15, etc., shall be described.

The effects of the water flow passage and the solvent flow passage are as described above.

In addition, in the present preferred embodiment, the high-temperature chemical liquid (sulfuric acid and SPM) is guided toward the substrate W by the high-temperature chemical liquid flow passage 132x. The high-temperature chemical liquid flow passage 132x includes the uneven surface 172 in contact with the high-temperature chemical liquid.

The uneven surface 172 of the high-temperature chemical liquid flow passage 132x includes the concave portion 172u at least partially filled with air and the convex portion 172h in contact with the high-temperature chemical liquid in contact with the air in the concave portion 172u. Since at least a portion of the concave portion 172u is filled with air, the contact area between the high-temperature chemical liquid and the uneven surface 172 is reduced as compared with the case where the entire concave portion 172u is filled with the high-temperature chemical liquid. Further, since the high-temperature chemical liquid does not come into contact with or hardly comes into contact with the inner surface of the concave portion 172u, a region where the high-temperature chemical liquid comes into contact with the uneven surface 172 can be limited. Since the range to be cleaned with the cleaning liquid is thereby narrowed, the cleaning time can be shortened.

In the present preferred embodiment, all or portion of the uneven surface 172 is made of fluororesin. The fluororesin is a material having high water repellency. Whether the droplet on the rough surface takes on the Wenzel state or the Cassie-Baxter state is affected by factors such as a surface tension of the liquid, a surface free energy of the rough surface (solid), and a surface property of the rough surface. By making the uneven surface 172 with a material having high water repellency, a state where at least a portion of the concave portion 172u is filled with air can be maintained. It is thereby possible to reduce the contact area between the high-temperature chemical liquid and the uneven surface 172 while limiting the region where the high-temperature chemical liquid is in contact with the uneven surface 172.

In the present preferred embodiment, a high-temperature chemical liquid (high-temperature sulfuric acid) is guided from the sulfuric acid tank 132t to the sulfuric acid piping 132p (high-temperature chemical liquid piping). The uneven surface 172 is provided on the inner surface of the sulfuric acid tank 132t. The time during which the high temperature sulfuric acid is in contact with the sulfuric acid tank 132t is longer than the time during which the high temperature sulfuric acid is in contact with the sulfuric acid piping 132p. Therefore, by reducing a contact area between the high temperature sulfuric acid and the sulfuric acid tank 132t, contaminants transferred from the sulfuric acid tank 132t to the high temperature sulfuric acid can be effectively reduced. In particular, when the sulfuric acid tank 132t made of fluororesin is used, it is possible to suppress the plasticizer from eluting and becoming impurities. Although this problem does not occur when the sulfuric acid tank 132t is made of quartz, the cost is high. Therefore, configuring the sulfuric acid tank 132t with a fluororesin overcomes the problem of elution of impurities (a plasticizer) while compressing the cost, which can improve the substrate processing quality and thus can improve the yield.

In the present preferred embodiment, SPM that is a high-temperature chemical liquid is generated, and the uneven surface 172 is provided on the inner surface of the second chemical liquid nozzle 132 through which the SPM flows and discharges the SPM from the discharge port 132d. While the discharge of the SPM from the second chemical liquid nozzle 132 is stopped, the SPM is retained in an interior of the second chemical liquid nozzle 132. Impurities (typically, a plasticizer) are eluted from the second chemical liquid nozzle 132 made of fluororesin into the retained SPM. Thereafter, when the SPM is discharged from the second chemical liquid nozzle 132 together with the eluted impurities and supplied to the substrate W, there is a possibility that processing failure occurs and a product yield is lowered. Therefore, by reducing a contact area between the SPM and the second chemical liquid nozzle 132, it is possible to effectively reduce contaminants transferred from the second chemical liquid nozzle 132 to the SPM, thereby reducing process defects.

In the present preferred embodiment, the uneven surface 172 is provided on the inner surface (at least the inner surface of the bent portion) of the sulfuric acid piping 132p constituting the high-temperature chemical liquid flow passage 132x. A region where the fluidity of the liquid is low (a region where stagnation and/or retention of the liquid occurs) may be generated in the bent portion. In such a case, it is considered that contaminants such as impurities (typically, a plasticizer) eluted from the resin material (fluororesins such as PTFE and PFA) constituting the sulfuric acid piping 132p accumulate in the bent portion and flow together with the high-temperature chemical liquid at an unexpected timing. When the uneven surface 172 is provided on the inner surface of the bent portion, since a resistance applied to the high-temperature chemical liquid from the inner surface of the bent portion is reduced, a decrease in the speed of high-temperature chemical liquid at the bent portion can be reduced, and a region where stagnation and/or retention of the high-temperature chemical liquid occur can be reduced. Therefore, impurities and foreign matters accumulated in such a region can be reduced, and contaminants moving from the inner surface of the bent portion to the high-temperature chemical liquid flowing in the bent portion can be reduced.

It is noted that, other than sulfuric acid and SPM, there are other chemical liquids supplied to the substrate at a temperature higher than room temperature, and for example, phosphoric acid is another example of the chemical liquid used at a high temperature.

Two or more of all of the configurations described above may be combined. Two or more of all of the steps described above may be combined.

Although the preferred embodiments of the present invention have been described in detail above, these are merely detailed examples used for clarifying the technical contents of the present invention, and the present invention should not be limitedly interpreted to these detailed examples, and the spirit and scope of the present invention should be limited only by the claims appended hereto.

## Claims

1. A substrate processing apparatus comprising:
a substrate holder that holds a substrate;
a water flow passage that guides water toward the substrate held by the substrate holder; and
a solvent flow passage that guides an organic solvent, which is a liquid having a surface tension lower than that of the water, toward the substrate held by the substrate holder,
wherein the water flow passage includes an uneven surface including a concave portion at least partially filled with air and a convex portion in contact with the water in contact with the air in the concave portion, and
wherein the solvent flow passage includes a mirror surface that is in contact with the organic solvent.

2. The substrate processing apparatus according to claim 1,
wherein the uneven surface is made of fluororesin.

3. The substrate processing apparatus according to claim 1 or 2,
wherein the water flow passage includes a water tank that stores the water and a water piping that guides the water supplied from the water tank, and
wherein the uneven surface is provided on an inner surface of the water tank.

4. The substrate processing apparatus according to claim 1 or 2,
wherein the solvent flow passage includes a solvent tank that stores the organic solvent and a solvent piping that guides the organic solvent supplied from the solvent tank, and
wherein the mirror surface is provided on an inner surface of the solvent tank.

5. The substrate processing apparatus according to claim 1 or 2,
wherein the uneven surface is provided at a bent portion of the water flow passage.

6. The substrate processing apparatus according to claim 1 or 2, further comprising:
a high-temperature chemical liquid flow passage that guides a high-temperature chemical liquid having a temperature higher than room temperature toward the substrate held by the substrate holder,
wherein the high-temperature chemical liquid flow passage includes an uneven surface including a concave portion at least partially filled with air and a convex portion in contact with the high-temperature chemical liquid in contact with the air in the concave portion.

7. The substrate processing apparatus according to claim 6,
wherein the uneven surface of the high-temperature chemical liquid flow passage is made of fluororesin.

8. The substrate processing apparatus according to claim 6,
wherein the high-temperature chemical liquid flow passage includes a high-temperature chemical liquid tank that stores the high-temperature chemical liquid, and a high-temperature chemical liquid piping that guides the high-temperature chemical liquid supplied from the high-temperature chemical liquid tank, and
wherein the uneven surface of the high-temperature chemical liquid flow passage is provided on an inner surface of the high-temperature chemical liquid tank.

9. The substrate processing apparatus according to claim 8,
wherein the uneven surface is provided at a bent portion of the high-temperature chemical liquid flow passage.

10. The substrate processing apparatus according to claim 6,
wherein the high-temperature chemical liquid flow passage includes a high-temperature chemical liquid piping that guides the high-temperature chemical liquid, and a high-temperature chemical liquid nozzle that discharges the high-temperature chemical liquid guided by the high-temperature chemical liquid piping, and
wherein the uneven surface of the high-temperature chemical liquid flow passage is provided on an inner surface of the high-temperature chemical liquid nozzle.

11. The substrate processing apparatus according to claim 10,
wherein the uneven surface is provided at a bent portion of the high-temperature chemical liquid flow passage.

12. A substrate processing method comprising:
a water supplying step of guiding water toward a substrate held by a substrate holder by a water flow passage including an uneven surface in a state where at least a portion of a concave portion of the uneven surface is filled with air and a convex portion of the uneven surface is in contact with the water in contact with the air in the concave portion; and
a solvent supplying step of guiding, before or after the water supplying step, an organic solvent toward the substrate held by the substrate holder by a solvent flow passage including a mirror surface, in a state where the mirror surface is in contact with the organic solvent which is a liquid having a surface tension lower than that of the water.

13. The substrate processing method according to claim 12, further comprising:
a high-temperature chemical liquid supplying step of guiding a high-temperature chemical liquid having a temperature higher than room temperature toward the substrate held by the substrate holder,
wherein the high-temperature chemical liquid supplying step includes a step of causing the high-temperature chemical liquid to flow through a high-temperature chemical liquid flow passage including the uneven surface in a state where at least a portion of the concave portion of the uneven surface is filled with air and the convex portion of the uneven surface is in contact with the high-temperature chemical liquid in contact with the air in the concave portion.

14. A substrate processing apparatus comprising:
a substrate holder that holds a substrate; and
a high-temperature chemical liquid flow passage that guides a high-temperature chemical liquid having a temperature higher than room temperature toward a substrate held by the substrate holder,
wherein the high-temperature chemical liquid flow passage includes an uneven surface including a concave portion at least partially filled with air and a convex portion in contact with the high-temperature chemical liquid in contact with the air in the concave portion.

15. The substrate processing apparatus according to claim 14, further comprising:
a solvent flow passage that guides an organic solvent, which is a liquid having a surface tension lower than that of the high-temperature chemical liquid toward the substrate held by the substrate holder,
wherein the solvent flow passage includes a mirror surface in contact with the organic solvent.

16. The substrate processing apparatus according to claim 14,
wherein the uneven surface is made of fluororesin.

17. The substrate processing apparatus according to claim 14,
wherein the high-temperature chemical liquid flow passage includes a high-temperature chemical liquid tank that stores the high-temperature chemical liquid, and a high-temperature chemical liquid piping that guides the high-temperature chemical liquid supplied from the high-temperature chemical liquid tank, and
wherein the uneven surface is provided on an inner surface of the high-temperature chemical liquid tank.

18. The substrate processing apparatus according to claim 14,
wherein the high-temperature chemical liquid flow passage includes a high-temperature chemical liquid piping that guides the high-temperature chemical liquid, and a high-temperature chemical liquid nozzle that discharges the high-temperature chemical liquid guided by the high-temperature chemical liquid piping, and
wherein the uneven surface is provided on an inner surface of the high-temperature chemical liquid nozzle.

19. The substrate processing apparatus according to claim 17 or 18,
wherein the uneven surface is provided at a bent portion of the high-temperature chemical liquid flow passage.

20. A substrate processing method comprising:
a high-temperature chemical liquid supplying step of guiding a high-temperature chemical liquid having a temperature higher than room temperature toward a substrate held by a substrate holder,
wherein the high-temperature chemical liquid supplying step includes a step of causing the high-temperature chemical liquid to flow through a high-temperature chemical liquid flow passage including an uneven surface in a state where at least a portion of the concave portion of the uneven surface is filled with air and the convex portion of the uneven surface is in contact with the high-temperature chemical liquid in contact with the air in the concave portion.

21. The substrate processing method according to claim 20, further comprising:
a solvent supplying step of guiding, before or after the high-temperature chemical liquid supplying step, an organic solvent toward the substrate held by the substrate holder by a solvent flow passage including a mirror surface, in a state where the mirror surface is in contact with the organic solvent, which is a liquid having a surface tension lower than that of the high-temperature chemical liquid.
